# EUROPEAN PATENT APPLICATION

(11) **EP 1 995 769 A1**
(43) Date of publication of application: **26.11.2008**
(21) Application number: 08163444.6
(22) Date of filing: 05.08.2004
(51) Int. Cl.: H01L 21/027, G03F 7/20

(54) **Exposure method and exposure apparatus, stage unit, and device manufacturing method**

(30) Priority: 07.08.2003 JP 2003288919
(62) Divisional of application: 04771271.6
(71) Applicant: Nikon Corporation, Tokyo 100-8331 (JP)
(72) Inventor: Shibazaki, Yuichi Nikon Corporation, Chiyoda-ku, Tokyo, 100-8831 (JP)
(74) Representative: Gill, David Alan

(57) **Abstract**

By an exposure method including a process where in parallel with an exposure operation performed on a wafer on one of the wafer stages (WST1), the other wafer stage (WST2) is temporarily positioned under the one wafer stage in order to interchange both wafer stages (WST1 and WST2), a part of the interchange operation (exchange operation) of both stages according to a procedure of temporarily positioning the other wafer stage under the one wafer stage can be performed in parallel with the exposure operation of the wafer on the one wafer stage. Accordingly, the interchange can be performed in a shorter period of time than when the interchange operation begins from the point where the exposure operation of the wafer on the one wafer stage has been completed.

## Description

The present invention relates to exposure methods and exposure apparatus, stage units, and device manufacturing method, and more particularly to an exposure method in which exposure of substrates on two substrate stages is alternately performed and an exposure apparatus, a stage unit that can be suitably employed in the exposure apparatus, and a device manufacturing method in which exposure is performed using the exposure apparatus.

Conventionally, various exposure apparatus have been used when manufacturing semiconductors devices (integrated circuits), liquid crystal displays devices, or the like in a lithography process. In recent years, due to higher integration of semiconductor devices, projection exposure apparatus of a sequentially moving type are mainly used, such as the reduction projection exposure apparatus (the so-called stepper) by the step-and-repeat method, and the scanning projection exposure apparatus by the step-and-scan method (the so-called scanning stepper (also called a scanner)), which is an improvement of the stepper.

For example, in the projection exposure apparatus used for manufacturing a semiconductor device, processing is repeatedly performed in three steps, which are a wafer exchange step where a wafer is exchanged on the wafer stage, a wafer alignment step for accurately obtaining the position of each shot area on the wafer, and an exposure step where the pattern formed on a reticle (or a mask) is transferred onto each shot area of the wafer while controlling the position of the wafer stage based on the wafer alignment results, using one wafer stage.

Exposure apparatus are used in mass production of semiconductor devices or the 1 ike. Therefore, improving the throughput is also one of the most important issues along with improving the exposure accuracy, and the requirements for improving the throughput of exposure apparatus actually see no end.

Therefore, recently, from the viewpoint of further improving the throughput, various proposals have been made (for example, refer to Patent Document 1 and Patent Document 2) on an exposure apparatus of the twin wafer stage type where two wafer stages are arranged, and using the two stages, for example, wafer exchange operation and alignment operation, and exposure operation are concurrently performed.

With the exposure apparatus according to patent document, by the simultaneous parallel processing described above on the two wafer stages, the throughput can be dramatically improved. However, in the exposure apparatus according to patent document1, the wafer alignment system having the alignment sensor is arranged on both sides of the projection optical system, and since alignment is alternately performed using each of the alignment sensors, it is necessary to present errors from occurring as much as possible in the alignment results. As a countermeasure to present such errors, measurement errors due to the alignment sensors have to be measured in advance for each of the two wafer alignment systems, and the wafer alignment results have to be corrected according to such measurement results. However, the operation of measuring the measurement errors due to the alignment sensors in advance as is described above may consequently become the cause of lowering the throughput. Furthermore, in this case, it is difficult to perform an adjustment where there are no measurement errors between the alignment sensors of the two wafer alignment systems.

Meanwhile, according to the apparatus in patent document 2, because only one characterization unit (corresponding to the wafer alignment system) is arranged, the throughput hardly decreases even when the measurement errors due to the alignment sensors are measured in advance as is described above since the measurement in advance has to be performed only for one unit. However, because there is only one characterization unit in the apparatus according to patent document 2, the two substrate holders equipped in the apparatus have to be interchanged in order to position each of the two holders below the characterization unit. As the interchanging method, in the apparatus according to patent document 2, the shifting method is employed where the substrate holders are each shifted by a coupling (a mechanical or an electronic mechanical coupling) of connecting members disposed on second sections (corresponding to movers), which move along first sections (stators) of two linear X motors (X-axis linear motors), respectively, and connecting members disposed on each of the two substrate holders. That is, a rigid coupling mechanism is employed for connecting each substrate holder (wafer stage) to the movers of the linear X motors. Therefore, in the apparatus according to patent document 2, the interchange of the substrate holders include a mechanically grasping operation, which is an operation with uncertainty that took a long time, and in order to perform the operation without fail, there was the inconvenience of having to accurately align the substrate holders to the second sections of the linear X motors. In addition, there was the possibility of the substrates (such as wafers) on the substrate holders to be displaced, due to the impact that occurs when the connecting members are connected.

Patent Document 1: Kokai (Japanese Unexamined Patent Application Publication) No. 10-163098.

Patent Document 2: Kohyo (Japanese Unexamined Patent Application Publication) No. 2000-511704.

The present invention has been made in consideration of the situation described above, and has as its first object to provided an exposure method and an exposure apparatus that improve the throughput without degrading the exposure accuracy, especially in the exposure processing step where exposure processing is alternately performed on a substrate on two substrate stages.

In addition, the second object of the present invention is to provide a device manufacturing method that can improve the productivity of microdevices.

According to a first aspect of the present invention, there is provided an exposure method in which exposure processing is performed alternately with respect to substrates on two substrate stages, the method comprising: a step in which while an exposure operation is performed on a substrate on one substrate stage, the other substrate stage is concurrently positioned temporarily below the one substrate stage so as to interchange both substrate stages.

According to the method, since the method includes a step in which while an exposure operation is performed on a substrate on one substrate stage, the other substrate stage is concurrently positioned temporarily below the one substrate stage so as to interchange both substrate stages, for example, a part of the interchange operation (exchange operation) of both substrate stages is performed according to a procedure of temporarily positioning the other substrate stage below one substrate stage, in parallel with the exposure operation with respect to the substrate on the one substrate stage. Therefore, the interchange can be performed within a shorter period of time compared with when the interchange operation of both substrate stages begins from the point when exposure operation on the substrate on one of the substrate stage has been completed, which makes it possible to improve the throughput of the exposure processing step of alternately performing exposure operation on the substrates on the two substrate stages. Further, the interchange of the wafer stages can be achieved by simply moving each of the wafer stages along a path decided in advance, without performing the operation with uncertainty as in a mechanically grasping operation previously described. Therefore, the position alignment that was necessary when mechanically grasping operation was performed will not be required, and displacement of the wafer will not occur, so the exposure accuracy will not be reduced in particular.

In this case, the step can be a step where the other substrate stage temporarily waits below the one substrate stage, or the step can be a part of a moving step where the other substrate stage moves between an alignment time frame and an exposure time frame with respect to a substrate.

According to a second aspect of the present invention, there is provided a first exposure apparatus that alternately performs exposure processing with respect to substrates on two substrate stages, the apparatus comprising: an exposure optical system that exposes a substrate on each of the two substrate stages positioned in the vicinity of a predetermined first position; a mark detection system that detects a mark formed on a substrate on each of the two substrate stages positioned at a second position different from the first position; and an exchange unit that switches the both substrate stages in between an exposure operation of a substrate by the exposure optical system and a mark detection operation of the substrate by the mark detection system, in a procedure where a specific stage, which is at least one of the two substrate stages, is temporarily positioned below the remaining substrate stage.

According to the apparatus, the apparatus is equipped with an exchange unit that switches the both substrate stages in between an exposure operation of a substrate by the exposure optical system and a mark detection operation of the substrate by the mark detection system, in a procedure where a specific stage, which is at least one of the two substrate stages, is temporarily positioned below the remaining substrate stage. Therefore, by the exchange unit, for example, a part of the interchange operation (exchange operation) of both substrate stages according to the procedure of temporarily positioning the other substrate stage on which detection operation of the marks on the substrate by the mark detection system in the vicinity of the second position has been completed under the one substrate stage can be performed, concurrently with the exposure operation by the exposure optical system to the substrate on the one substrate stage positioned in the vicinity of the first position. Accordingly, the interchange can be performed within a shorter period of time compared with when the interchange operation of both substrate stages begins from the point when exposure operation on the substrate on one of the substrate stage has been completed, which makes it possible to improve the throughput of the exposure processing step of alternately performing exposure operation on the substrates on the two substrate stages. Further, the interchange of the wafer stages can be achieved by simply moving each of the wafer stages along a path decided in advance, without performing the operation with uncertainty as in a mechanically grasping operation previously described. Therefore, the position alignment that was necessary when mechanically grasping operation was performed will not be required, and displacement of the wafer will not occur, so the exposure accuracy will not be reduced in particular. In addition, since only one mark detection system is required, the inconvenience previously described due to having a plurality of mark detection systems will be resolved.

In this case, the exchange unit can make the specific stage wait below the remaining substrate stage.

Further, in the case the specific stage is one substrate stage of the two substrate stages, the exchange unit can move the specific stage via the lower side of the other stage.

In this case, the exchange unit can be configured including a first vertical mechanism that vertically moves the specific stage between the second position and a third position below the second position, and a second vertical mechanism that vertically moves the specific stage between a fourth position on the opposite side of the second position with respect to the first position and a fifth position below the fourth position.

According to a third aspect of the present invention, there is provided a second exposure apparatus that performs exposure processing on a substrate held on a stage that can move along a predetermined plane, the apparatus comprising: a drive unit connecting to the stage that drives the stage along the predetermined plane; and a vertical movement mechanism that moves the stage and at least a part of the drive unit in a direction intersecting the predetermined plane.

In this case, the apparatus can further comprise: an exposure optical system, wherein when the stage moves along the predetermined plane, an image-forming plane of the exposure optical system can be positioned on the substrate held on the stage.

Further, the drive unit can move the stage in the direction intersecting the predetermined plane independently from the vertical movement mechanism.

Further, a predetermined first position where exposure processing of the substrate held on the stage is performed and a second position where a processing different from the exposure processing is performed on the substrate can be set, and the vertical movement mechanism can move the stage and at least a part of the drive unit in the direction intersecting the predetermined plane in the vicinity of the second position.

In this case, the second position can include a loading position of the substrate, or the apparatus can further comprise: a mark detection system arranged in the vicinity of the second position that detects marks formed on the substrate.

In the second exposure apparatus of the present invention, the apparatus can further comprise: a first guide surface that supports the stage when the stage moves along the predetermined plane, and a second guide surface that supports the stage, which moves in the direction intersecting the predetermined plane, by the vertical movement mechanism.

In this case, the vertical movement mechanism can move the second guide surface in the direction intersecting the predetermined plane.

According to a fourth aspect of the present invention, there is provided a first stage unit, the unit comprising: a stage that can move along a predetermined plane; a first drive unit connected to the stage that makes the stage move along the predetermined plane; a vertical movement mechanism that moves the stage and at least a part of the first drive unit in a direction intersecting the predetermined plane.

In this case, the unit can further comprise: a first guide surface that supports the stage when the stage moves along the predetermined plane, and a second guide surface that that supports the stage that moves in the direction intersecting the predetermined plane by the vertical movement mechanism; and a second drive unit that drives the stage supported by the second guide surface.

Further, the vertical movement mechanism can move the second guide surface in the direction intersecting the predetermined plane.

According to a fifth aspect of the present invention, there is provided a second stage unit that alternately moves two stages with respect to a predetermined position for performing a predetermined processing, the unit comprising: an exchange unit that moves only one stage of the two stages so that the one stage is temporarily positioned under the other stage.

In this case, the exchange unit can include a vertical movement mechanism that vertically moves the one stage so as to position the one stage lower than a moving plane of the other stage.

Further, in a lithography process, by performing exposure using one of the first and second exposure apparatus of the present invention, a pattern can be formed on a substrate with good precision, which makes it possible to produce high-integration microdevices with good yield. Accordingly, it can also be said from another aspect that the present invention is a device manufacturing method that uses one of the first and second exposure apparatus of the present invention.
FIG. 1 is a view that schematically shows a configuration of an exposure apparatus in an embodiment of the present invention;
FIG. 2 is a perspective view that shows a wafer stage unit in FIG. 1;
FIG. 3 is an exploded perspective view of the wafer stage unit in FIG.2;
FIG. 4A is a view (No. 1) that shows a mover of a Y-axis linear motor;
FIG. 4B is a view (No. 2) that shows a mover of a Y-axis linear motor;
FIG. 5 is a perspective view (No. 1) that shows a guide mechanism;
FIG. 6 is a perspective view (No. 2) that shows a guide mechanism;
FIG. 7A is a is a perspective view that shows a partially broken view of a frame of a moving unit MUT1;
FIG. 7B is a perspective view of a wafer stage;
FIG. 8A is a view (No. 1) used to describe an exposure processing sequence;
FIG. 8B is a view (No. 2) used to describe an exposure processing sequence;
FIG. 8C is a view (No. 3) used to describe an exposure processing sequence;
FIG. 9A is a view (No. 4) used to describe an exposure processing sequence;
FIG. 9B is a view (No. 5) used to describe an exposure processing sequence;
FIG. 9C is a view (No. 6) used to describe an exposure processing sequence;
FIG. 10A is a view (No. 7) used to describe an exposure processing sequence;
FIG. 10B is a view (No. 8) used to describe an exposure processing sequence;
FIG. 10C is a view (No. 9) used to describe an exposure processing sequence;
FIG. 11 is flow chart used to explain an embodiment of a device manufacturing method according to the present invention; and
FIG. 12 is flow chart that shows a concrete example related to step 204 in Fig. 11.

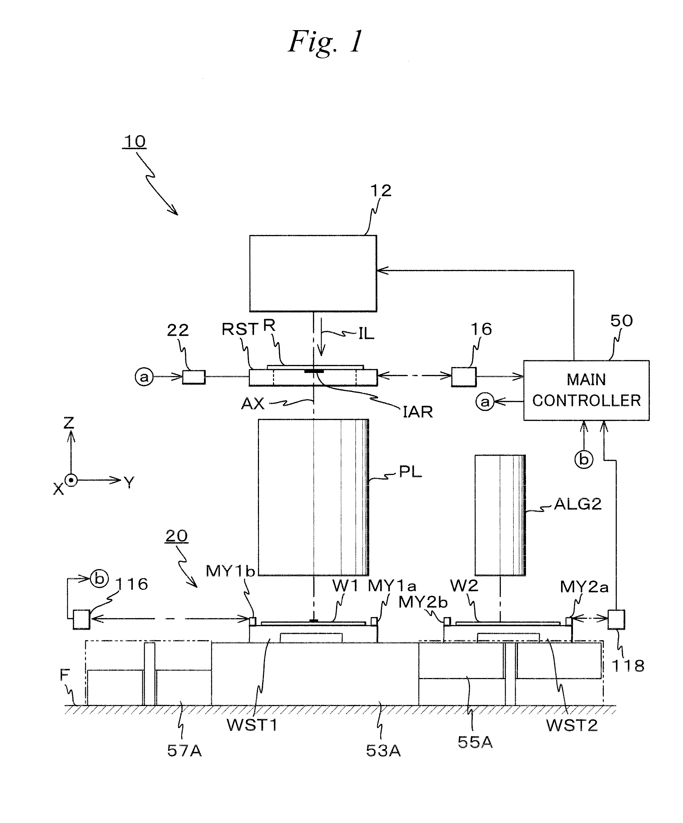

An embodiment of the present invention will be described, referring to FIGS. 1 to 10C. FIG. 1 shows a schematic view of an exposure apparatus 10 of the embodiment.

Exposure apparatus 10 is a scanning exposure apparatus by the step-and-scan method, or the so-called scanning stepper (also called a scanner) that transfers a circuit pattern formed on a reticle R serving as a mask onto each of a plurality of shot areas on a wafer W1 (or W2) serving as a photosensitive object, via a projection optical system PL serving as an exposure optical system, while synchronously moving reticle R and wafer W1 (or W2) in an one-dimensional direction (in this case, a Y-axis direction, which is the lateral direction of the page surface in FIG. 1).

Exposure apparatus 10 is equipped with an illumination system 12 that illuminates a reticle R with an illumination light IL, a reticle stag RST on which reticle R is mounted, projection optical system PL that projects illumination light IL outgoing from reticle R onto wafer W1 (or W2), a stage unit 20 that includes two substrate stages on which wafers W1 and W2 are respectively mounted, that is, wafer stages WST1 and WST2, an alignment system ALG serving as a mark detection system, a main controller 50 that has overall control over the entire unit, and the like.

Illumination system 12 includes a light source and an illumination optical system, and irradiates illumination light IL on a rectangular or an arc-shaped illumination area IAR set by a field stop (also called a masking blade or a reticle blind) disposed inside the system, and illuminates reticle R on which the circuit pattern is formed with uniform illuminance. An illumination system similar to illumination system 12 is disclosed in, for example, Kokai (Japanese Unexamined Patent Application Publication) No. 6-349701, and the corresponding U.S. Patent No. 5,534,970, and the like. As illumination light IL, far ultraviolet light such as a KrF excimer laser beam (wavelength 248 nm) or an ArF excimer laser beam (wavelength 193 nm), or vacuum ultraviolet light such as an F₂ laser beam (wavelength 157 nm), or the like is used. Also, it is possible to use on emission line (such as a g-line or an i-line) in an ultraviolet region emitted from an ultra high-pressure mercury lamp as illumination light IL. As long as the national laws in designated states (or elected states), to which this international application is applied, permit, the above disclosures of the publication and the U.S. Patent are incorporated herein by reference.

On reticle stage RST, for example, reticle R is fixed by vacuum chucking, electrostatic suction, or the like. Reticle stage RST is finely drivable in an X-axis direction, a Y-axis direction, and a θz direction (rotation direction around a Z-axis) within an XY plane perpendicular to the optical axis of illumination system 12 (coincides with an optical axis AX of projection optical system PL that will be described later) by a reticle stage drive section 22. Reticle stage RST is also drivable in a predetermined scanning direction (the Y-axis direction) along the upper surface of a reticle stage base (not shown) at a designated scanning speed. Reticle stage drive section 22 is a mechanism that uses a linear motor or a voice coil motor as its drives source, however, in FIG. 1, reticle stage drive section 22 is shown simply as a block for the sake of convenience. As reticle stage RST, it is a matter of course that a stage that has a rough/fine movement structure can be employed, which has a rough movement stage drivable one dimensionally in the Y-axis direction, and a fine movement stage that can finely drive reticle R in at least directions of three degrees of freedom (the X-axis direction, the Y-axis direction, and the θz direction) with respect to the rough movement stage.

The position (including the θz rotation) of reticle stage RST within the XY plane is constantly detected by a reticle laser interferometer (hereinafter referred to as 'reticle interferometer') 16 via a reflection surface formed (or arranged) on the edge section of reticle stage RST at a resolution of, for example, around 0.5 to 1 nm. The position information (including rotation information such as the θz rotation (yawing amount)) of reticle stage RST from reticle interferometer 16 is supplied to main controller 50. Main controller 50 controls the drive of reticle stage RST via reticle stage drive section 22, based on the position information of reticle stage RST.

As projection optical system PL, a both-side telecentric reduction system on the object surface side (reticle side) and the image plane side (wafer side) whose projection magnification is 1/4 (or 1/5) is used. Therefore, when illumination light (pulsed ultraviolet light) IL is irradiated on reticle R from illumination system 12, the imaging beams from the circuit pattern area formed on reticle R illuminated with the pulsed ultraviolet light enters projection optical system PL, and the image (a partially inverted image) of the circuit pattern within the irradiation area (illumination area IAR previously described) of illumination light IL is formed in the center of a field on the image plane side of projection optical system PL, limited in a narrow slit shape (or a rectangular shape (polygon)) extending in the X-axis direction, each time the purse irradiation of the pulsed ultraviolet light is performed. With this operation, the partially inverted image of the circuit pattern projected is reduced and transferred onto a resist layer on the surface of a shot area among a plurality of shot areas on wafer M1 (or M2), which is disposed on the image-forming plane of projection optical system PL.

In the case the KrF excimer laser beam or the ArF excimer laser beam is used as illumination light IL in projection optical system PL, a refracting system consisting of only a dioptric system (lens elements) is mainly used. However, in the case of using the F₂ laser beam as illumination light IL, a so-called catadioptric system, which is a combination of dioptric elements and catoptric elements (such as a concave mirror or a beam splitter), or a reflection system consisting of only reflection optical elements, is mainly used, such as the ones disclosed in, for example, Kokai (Japanese Unexamined Patent Application Publication) No. 3-282527, and the corresponding U.S. Patent No. 5,220,454. However, in the case of using the F₂ laser beam, it is also possible to use a refracting system. As long as the national laws in designated states (or elected states), to which this international application is applied, permit, the above disclosures of the publication and the U.S. Patent are incorporated herein by reference.

Stage unit 20 is disposed below projection optical system PL in FIG. 1. Stage unit 20 is equipped with wafer stages WST1 and MST2 that hold wafers M1 and W2, a drive mechanism that drives wafer stages MST1 and WST2, and the like.

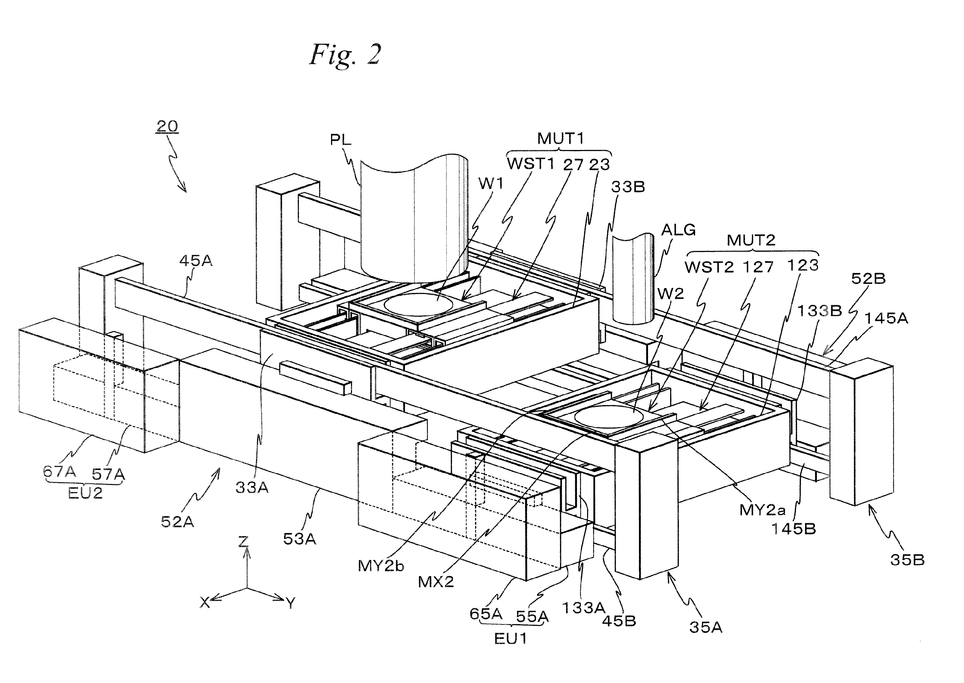

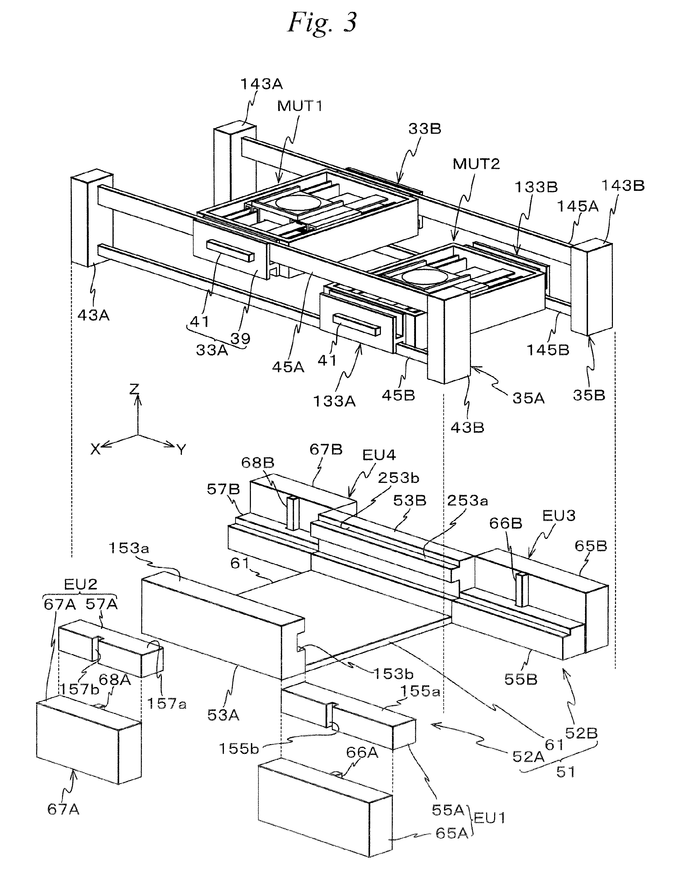

FIG. 2 is a perspective view that schematically shows stage unit 20, along with projection optical system PL, alignment system ALG, and the like, and FIG. 3 shows an exploded perspective view of stage unit 20. The configuration and the like of stage unit 20 will now be described, focusing on FIGS. 2 and 3, and referring to other drawings as appropriate.

As is shown in FIG. 2, one of the wafer stages, wafer stage WST1 is assembled into a frame 23 that has a rectangular shape in a planar view (when viewed from above), which constitutes a moving unit MUT1. Similarly, as is shown in FIG. 2, the other wafer stage, wafer stage WST2 also is assembled into a frame 123 has a rectangular shape in a planar view (when viewed from above), which constitutes a moving unit MUT2.

One of the moving units, moving unit MUT1, is reciprocally driven within a plane (a first plane) parallel to the XY plane shown in FIG. 2 in the Y-axis direction, between a first position below projection optical system PL and a second position below alignment system ALG by a drive system, which will be described later in the description. In addition, the other moving unit, moving unit MUT2 is reciprocally driven within the first plane as in moving unit MUT1, and besides this movement, the unit is also driven vertically, between the second position and a third position, which is below the second position, as well as between a fourth position, which is on the opposite side of the second position with respect to the first position, and a fifth position below the fourth position. The moving unit MUT2 is also reciprocally driven between the third position and the fifth position in the Y-axis direction along a second surface (that is, the surface where moving unit MUT2 is positioned in FIG. 2) below the first surface.

As is obvious from FIG. 2, one of the moving units, moving unit MUT1 is configured including frame 23, which has a rectangular frame shape in a planar view (when viewed from above), a stator unit 27, which includes a group of stators installed between one side wall and the other side wall off frame 23 in the X-axis direction whose longitudinal direction is in the X-axis direction, and wafer stage WST1, which engages with the group of stators constituting stator unit 27 and can be relatively moved.

Similarly, as is obvious from FIG. 2, the other moving unit, moving unit MUT2 is configured including frame 123, which has a rectangular frame shape in a planar view (when viewed from above), a stator unit 127, which includes a group of stators installed between one side wall and the other side wall of frame 123 in the X-axis direction whose longitudinal direction is in the X-axis direction, and wafer stage WST2, which engages with the group of stators constituting stator unit 127 and can be relatively moved.

As frames 23 and 123, a carbon monocoque frame, which is lightweight, is used.

As is shown in FIG. 2, on the outer surface of the side wall of frame 23 on one side (the +X side) and the other side (-X side) of frame 23 in the X-axis direction, Y movers 33A and 33B are arranged, respectively. Similarly, on the outer surface of the side wall of frame 123 on one side (the +X side) and the other side (-X side) of frame 123 in the X-axis direction, Y movers 133A and 133B are arranged, respectively, as is shown in FIG. 2.

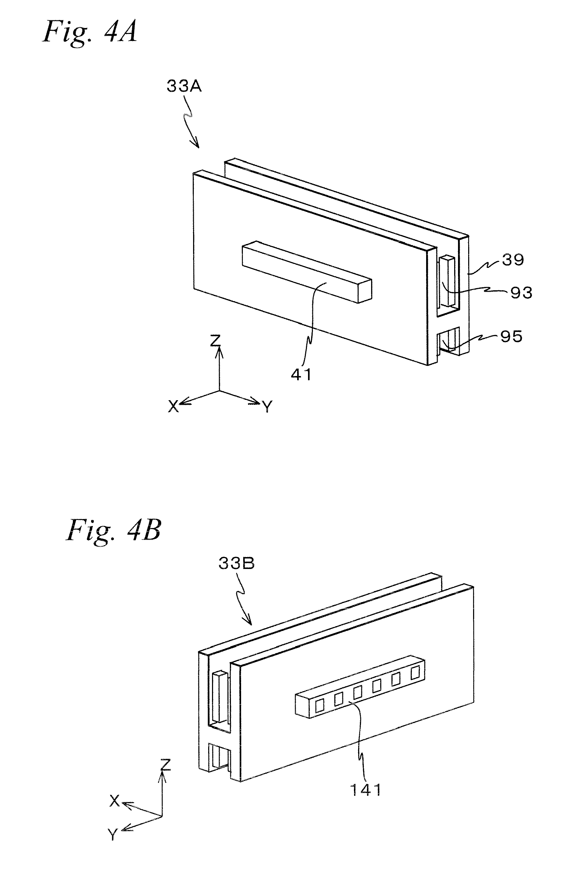

As is shown extracted in FIG. 4A, one of the Y movers, Y mover 33A arranged in frame 23 is a magnetic unit that has a mover main body 39 being roughly shaped in the letter H in an XZ section, and of two sets of opposing surfaces in the X-axis direction that are vertically arranged in mover main body 39, the magnetic unit has a plurality of field magnets 93 that are each disposed along the Y-axis direction at a predetermined distance on the upper opposing surfaces in the X-axis direction, and a plurality of field magnets 95 that are each disposed along the Y-axis direction at a predetermined distance on the lower opposing surfaces.

The adjacent field magnets in the Y-axis direction and the opposing field magnets in the X-axis direction each have a reversed polarity in the plurality of field magnets 93 and 95. Therefore, in the spaces vertically arranged inside mover main body 39, an alternating magnetic field (the direction of the magnetic flux is in the +X direction or the -X direction) is formed in the Y-axis direction, respectively. In addition, on the +X side surface of mover main body 39 at substantially the center in the Z-axis direction, a gas hydrostatic bearing 41 is fixed. In gas hydrostatic bearing 41, an outlet of the pressurized gas is formed on its lower surface (the -Z side surface).

As is shown extracted in FIG. 4B, a magnetic unit substantially the same as Y mover 33A is used as the other Y mover, Y mover 33B, arranged in frame 23, however, a gas hydrostatic bearing 141, which is arranged on the -X side surface, is different from gas hydrostatic bearing 41 arranged in Y mover 33A. More specifically, gas hydrostatic bearing 141 has a gas outlet not only or the -Z surface side (the lower surface) but also on the -X surface side (the side surface).

One of the Y movers, Y mover 133A, arranged in frame 123 is constituted in the same manner as Y mover 33A previously described, and the other Y mover, Y mover 133B is also constituted in the same manner as Y mover 33B previously described.

As is shown in the exploded perspective view in FIG. 3, the drive system is equipped with a pair of stator units 35A and 35B that engages with Y movers 33A and 33B, and Y movers 133A and 133B, and a guide mechanism 51 mainly composed of a plurality of members disposed outside stator units 35A and 35B.

As it can be seen when viewing both FIGS. 2 and 3, stator unit 35A is disposed on a floor surface F in the Y-axis direction at a predetermined distance. The stator unit has a pair of support columns 43A and 43B extending in the vertical direction, and two Y stators 45A and 45B whose longitudinal direction is the Y-axis direction, installed between support columns 43A and 43B and disposed vertically at a predetermined distance.

Y stators 45A and 45B are armature units each having a housing whose XZ section is a narrow rectangle in the Z-axis direction, and a plurality of armature coils (not shown) disposed inside the housing along the Y-axis direction at a predetermined distance.

Y stator 45A on the upper side has a shape that can engage with the spaces on the upper side of Y movers 33A and 133A (that is, the spaces where field magnets 93 are arranged), whereas Y stator 45B on the lower side has a shape that can engage with the spaces on the lower side of Y movers 33A and 133A (that is, the spaces where field magnets 95 are arranged). However, in the embodiment, due to structural reasons, Y mover 33A does not actually engage with Y stator 45B.

As it can be seen when viewing both FIGS. 2 and 3 together, stator unit 35B is disposed on a floor surface F in the Y-axis direction at a predetermined distance. The stator unit has a pair of support columns 143A and 143B extending in the vertical direction, and two Y stators 145A and 145B whose longitudinal direction is the Y-axis direction, installed between support columns 143A and 143B and disposed vertically at a predetermined distance.

Y stators 145A and 145B are armature units each having a housing whose XZ section is a narrow rectangle in the Z-axis direction, and a plurality of armature coils (not shown) disposed inside the housing along the Y-axis direction at a predetermined distance.

Y stator 145A on the upper side has a shape that can engage with the spaces on the upper side of Y movers 33B and 133B, whereas Y stator 145B on the lower side has a shape that can engage with the spaces on the lower side of Y movers 33B and 133B. However, in the embodiment, due to structural reasons, Y mover 33B does not actually engage with Y stator 145B.

In the embodiment, moving unit MUT1 is on a plane arranged at the height shown in FIG. 3 (the first surface described earlier), and Y mover 33A is engaged with Y stator 45A and Y mover 33B is engaged with Y stator 145A. Then, the reaction force of the Lorentz force generated by the electromagnetic interaction between the current that flows in the armature coil that constitutes Y stator 45A and the alternating magnetic field generated by field magnets (field magnets on the upper side) 93 installed in Y mover 33A acts on Y mover 33A as a drive force in the Y-axis direction, and the reaction force of the Lorentz force generated by the electromagnetic interaction between the current that flows in the armature coil that constitutes Y stator 145A and the alternating magnetic field generated by field magnets 93 installed in Y mover 33B also acts on Y mover 33B as a drive force in the Y-axis direction.

More specifically, Y mover 33A and Y stator 45A constitute a moving magnet type Y-axis linear motor, and Y mover 33B and Y stator 145A also constitute a moving magnet type Y-axis linear motor, and by the pair of Y-axis linear motors, moving unit MUT1 is reciprocally driven in the Y-axis direction in predetermined strokes. In the description below, the pair of Y-axis linear motors will each be referred to as Y-axis linear motor 33A and Y-axis linear motor 33B, respectively, using the same reference numerals as the respective movers.

Further, when moving unit MUT2 is on a plane arranged at the height shown in FIGS. 2 and 3, Y mover 133A is engaged with Y stator 45B on the lower side and Y mover 133B is engaged with Y stator 145B on the lower side. And in this state, Y mover 133A and Y stator 45B constitute a moving magnet type Y-axis linear motor by the electro-magnetic drive method, and Y mover 133B and Y stator 145B also constitute a moving magnet type Y-axis linear motor by the electro-magnetic drive method, and by the pair of Y-axis linear motors, moving unit MUT2 set at the height shown in FIGS. 2 and 3 is reciprocally driven on the second surface previously described in the Y-axis direction in predetermined strokes. In the description below, the pair of Y-axis linear motors will each be referred to as Y-axis linear motor 45B and Y-axis linear motor 145B_{.} respectively, using the same reference numerals as the respective stators.

In the embodiment, moving unit MUT2 is driven upward by a first vertical movement mechanism and a second vertical movement mechanism, which will be described later, and is also made to be positioned at the same height position as moving unit MUT1 in FIGS. 2 and 3. At this position, Y mover 133A is engaged with Y stator 45A on the upper side and Y mover 133B is engaged with Y stator 145A on the upper side. And in this state, Y mover 133A and Y stator 45A constitute a moving magnet type Y-axis linear motor by the electro-magnetic drive method, and Y mover 133B and Y stator 145A also constitute a moving magnet type Y-axis linear motor by the electro-magnetic drive method, and by the pair of Y-axis linear motors, moving unit MUT2 set at the same height as MUT1 shown in FIGS. 2 and 3 is reciprocally driven on the first surface previously described in the Y-axis direction in predetermined strokes. In the description below, the pair of Y-axis linear motors will each be referred to as Y-axis linear motor 45A and Y-axis linear motor 145A, respectively, using the same reference numerals as the respective stators.

As is shown in FIG. 3, guide mechanism 51 is equipped with a first guide section 52A and a second guide section 52B, disposed at a predetermined distance in the X-axis direction, and a connecting plate 61 for connecting a part of the guide sections.

The structure of each section of guide mechanism 51 will be further described in detail. As is shown in FIG. 2, the first guide section 52A is disposed on the +X side of stator unit 35A previously described, and the second guide section 52B is disposed on the -X side of stator unit 35B previously described.

As it can be seen when viewing both FIGS. 2 and 3 together, the first guide section 52A is configured of three sections; a fixed guide 53A, arranged on floor surface F facing Y stator 45B constituting stator unit 35A at substantially the center of the longitudinal direction, an elevator unit EU1 arranged on one side (the +Y side) of fixed guide 53A in the Y-axis direction, and an elevator unit EU2 arranged on the other side (the -Y side) of fixed guide 53A in the Y-axis direction.

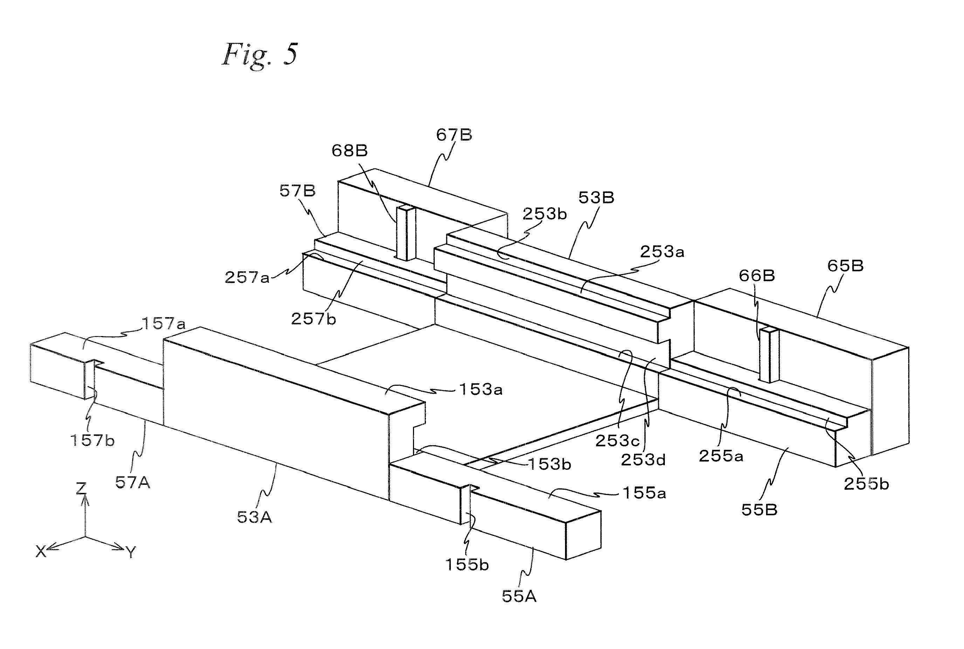

As is shown in FIG. 3, fixed guide 53A is composed of a generally cuboid member whose longitudinal direction is in the Y-axis direction and has a recessed groove with a rough U-shaped section formed on the surface on the -X side, and the upper end surface of the cuboid member is a first guide surface 153a shown in FIG. 5. Further, of a pair of opposing surfaces of the recessed groove formed at the center in the height direction on the -X side of fixed guide 53A, the surface on the lower side is a second guide surface 153b shown in FIGS. 3 and 5. The pressurized gas from gas hydrostatic bearing 41 arranged in Y mover 33A or Y mover 133A blows on the first guide surface 153a, and by the static pressure of the pressurized gas, moving unit MUT1 or moving unit MUT2 is supported by levitation in a non-contact manner, via a clearance of several µm between gas hydrostatic bearing 41 and guide surface 153a. Further, the pressurized gas from gas hydrostatic bearing 41 arranged in moving unit MUT2, which is at the height position shown in FIG. 3 or the like, blows on the second guide surface 153b, and by the static pressure of the pressurized gas, moving unit MUT2 is supported by levitation in a non-contact manner, via a clearance of several µm between gas hydrostatic bearing 41 and guide surface 153b.

As is shown in FIG. 2, elevator unit EU1 has a fixed block 65A composed of a cuboid member, which is disposed diagonally to fixed guide 53A at a position both on the +Y side and the +X side of fixed guide 53A, and a square-prism shaped vertical movement guide 55A whose longitudinal direction is the Y-axis direction, disposed on the -X side of fixed block 65A and has a guide groove 155b in the vertical direction as is shown in FIG. 3 on the surface on the +X side.

In this case, movers are embedded inside guide groove 155b of vertical movement guide 55A, and facing the movers on the surface on the -X side of fixed block 65A, a stator 66A, which configures a shaft motor (or a linear motor) along with the mover, is arranged (refer to FIG. 3).

In the embodiment, the shaft motor drives vertical movement guide 55A in the vertical direction (the Z-axis direction) with respect to fixed block 65A. In the following description, the shaft motor will be referred to as shaft motor 66A, using the same reference numerals as the stator.

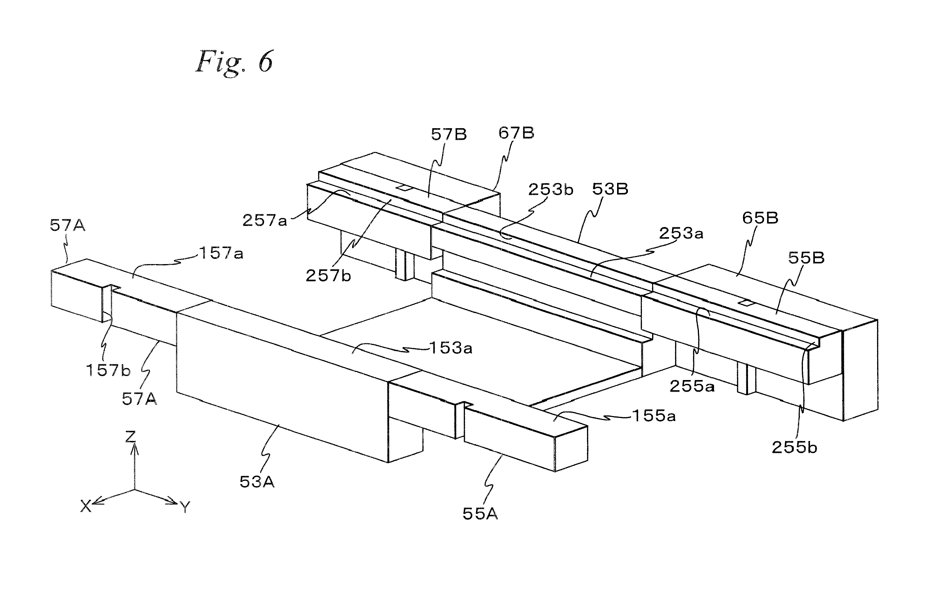

The upper surface of vertical movement guide 55A, an upper surface 155a, is a guide surface 155a, and the pressurized gas from gas hydrostatic bearing 41 arranged in Y mover 133A blows on guide surface 155a. Vertical movement guide 55A is driven by shaft motor 66A, between a lower moving limit position shown in FIG. 5 where guide surface 155a becomes in plane with the second guide surface 153b and an upper moving limit position shown in FIG. 6 where guide surface 155a becomes in plane with the first guide surface 153a.

As is shown in FIG. 2, elevator unit EU2 has a fixed block 67A composed of a cuboid member, which is disposed diagonally to fixed guide 53A at a position both on the -Y side and the +X side of fixed guide 53A, and a square-prism shaped vertical movement guide 57A whose longitudinal direction is the Y-axis direction, disposed on the -X side of fixed block 67A and has a guide groove 157b in the vertical direction as is shown in FIG. 3 on the surface on the +X side.

In this case, movers are embedded inside guide groove 157b of vertical movement guide 57A, and facing the movers on the surface on the -X side of fixed block 67A, a stator 68A, which configures a shaft motor (or a linear motor) along with the mover, is arranged (refer to FIG. 3).

In the embodiment, the shaft motor drives vertical movement guide 57A in the vertical direction (the Z-axis direction) with respect to fixed block 67A. In the following description, the shaft motor will be referred to as shaft motor 68A, using the same reference numerals as the stator.

The upper surface of vertical movement guide 57A is a guide surface 157a, and the pressurized gas from gas hydrostatic bearing 41 arranged in Y mover 133A blows on guide surface 157a. Vertical movement guide 57A is driven by shaft motor 68A, between a lower moving limit position shown in FIG. 5 where guide surface 157a becomes in plane with the second guide surface 153b and an upper moving limit position shown in FIG. 6 where guide surface 157a becomes in plane with the first guide surface 153a.

As it can be seen when viewing both FIGS. 2 and 3 together, the second guide section 52B is configured of three sections; a fixed guide 53B, arranged on floor surface F facing Y stator 145B constituting stator unit 35B at substantially the center of the longitudinal direction, an elevator unit EU3 arranged on one side (the +Y side) of fixed guide 53B in the Y-axis direction, and an elevator unit EU4 arranged on the other side (the -Y side) of fixed guide 53B in the Y-axis direction.

As is shown in FIG. 3, fixed guide 53B is composed of a generally cuboid member whose longitudinal direction is in the Y-axis direction, and on the upper end section on the +X side surface, a step section with an L-shaped section is formed, and below the step section, a recessed groove with a rough U-shaped section is formed. The upper surface of the step section with the L-shaped section of fixed guide 53B is a guide surface 253a and the side surface is a guide surface 253b. Further, of a pair of opposing surfaces of the recessed groove of fixed guide 53B, the surface on the lower side is a guide surface 253c shown in FIG. 5, and the inner bottom surface of the recessed groove (the surface on the +X side) is a guide surface 253d. Fixed guide 53B is disposed on the floor surface in a state facing fixed guide 53A previously described, and is connected to fixed guide 53A via connecting plate 61.

The pressurized gas from the outlet on the lower surface of gas hydrostatic bearing 141 arranged in Y mover 33B or Y mover 133B blows on guide surface 253a, and by the static pressure of the pressurized gas, moving unit MUT1 or moving unit MUT2 is supported by levitation in a noun-contract manner, via a clearance of several µm between gas hydrostatic bearing 41 and guide surface 253a. Further, the pressurized gas from the outlet on the side surface of gas hydrostatic bearing 141 blows on guide surface 253b and by the static pressure of the pressurized gas, a clearance of around several µm is maintained between gas hydrostatic bearing 141 and guide surface 253b. More specifically, guide surface 253b also functions as a yaw guide to moving unit MUT1 or MUT2.

The pressurized gas from the outlet on the lower surface of gas hydrostatic bearing 141, arranged in moving unit MUT2 at the height position shown in FIG. 3 or the like, blows on guide surface 253c, and by the static pressure of the pressurized gas, moving unit MUT2 is supported by levitation in a non-contact manner, via a clearance of several µm between gas hydrostatic bearing 141 and guide surface 253c. Further, the pressurized gas from the outlet on the side surface of gas hydrostatic bearing 141 blows on guide surface 253d and by the static pressure of the pressurized gas, a clearance of around several µm is maintained between gas hydrostatic bearing 141 and guide surface 253d. More specifically, guide surface 253d also functions as a yaw guide to moving unit MUT2.

As is shown in FIG. 5 or the like, elevator unit EU3 has a fixed block 65B composed of a cuboid member, which is disposed diagonally to fixed guide 53B at a position both on the +Y side and the -X side of fixed guide 53B, and a square-prism shaped vertical movement guide 55B whose longitudinal direction is the Y-axis direction, disposed on the +X side of fixed block 65B.

In this case, a guide groove of the vertical direction that has movers (not shown) embedded inside is formed on the surface of vertical movement guide 55B on the +X side, and facing the groove, a stator 66B, which configures a shaft motor (or a linear motor) along with the mover, is arranged.

In the embodiment, the shaft motor drives vertical movement guide 55B in the vertical direction (the Z-axis direction) with respect to fixed block 65B. In the following description, the shaft motor will be referred to as shaft motor 66B, using the same reference numerals as the stator.

In vertical movement guide 55B, guide surfaces 255a and 255b are formed that become flush with guide surfaces 253c and 253d described earlier, respectively, in a state shown in FIG. 5. In this case, pressurized gas from the outlet on the lower surface of gas hydrostatic bearing 141, arranged in Y mover 133B of moving unit MUT2 at the height position shown in FIG. 3 or the like, blows on guide surface 255a, and by the static pressure of the pressurized gas, moving unit MUT2 is supported by levitation in a non-contact manner, via a clearance of several µm between gas hydrostatic bearing 141 and guide surface 255a. Further, the pressurized gas from the outlet on the side surface of gas hydrostatic bearing 141 blows on guide surface 255b and by the static pressure of the pressurized gas, a clearance of around several µm is maintained between gas hydrostatic bearing 141 and guide surface 255b. More specifically, in this case, guide surface 255d also function as a yaw guide to moving unit MUT2.

Vertical movement guide 55B is driven by shaft motor 66B, between the lower moving limit position shown in FIG. 5 where guide surface 255a becomes in plane with guide surface 253c and the upper moving limit position shown in FIG. 6 where guide surface 255a becomes in plane with guide surface 253a.

When vertical movement guide 55B is at the upper moving limit position, and moving unit MUT1 is on vertical movement guide 55B, pressurized gas from the outlet on the lower surface of gas hydrostatic bearing 141, arranged in Y mover 33B of moving unit MUT1 blows on guide surface 255a, and by the static pressure of the pressurized gas, moving unit MUT1 is supported by levitation in a non-contact manner, via a clearance of several µm between gas hydrostatic bearing 141 and guide surface 255a. Further, the pressurized gas from the outlet on the side surface of gas hydrostatic bearing 141 blows on guide surface 255b and by the static pressure of the pressurized gas, a clearance of around several µm is maintained between gas hydrostatic bearing 141 and guide surface 255b. More specifically, guide surface 255b also function as a yaw guide to moving unit MUT1.

As is shown in FIG. 5 or the like, elevator unit EU4 has a fixed block 67B composed of a cuboid member, which is disposed diagonally to fixed guide 53B at a position both on the -Y side and the -X side of fixed guide 53B, a square-prism shaped vertical movement guide 57B whose longitudinal direction is the Y-axis direction, disposed on the +X side of fixed block 67B, a shaft motor 68B, and the like, and is configured similarly to elevator unit EU3 described above.

In vertical movement guide 57B, guide surfaces 257a and 257b are formed that become flush with guide surfaces 253c and 253d described earlier, respectively, in a state shown in FIG. 5. In this case, pressurized gas from the outlet on the lower surface of gas hydrostatic bearing 141, arranged in Y mover 133B of moving unit MUT2 at the height position shown in FIG. 3 or the like, blows on guide surface 257a, and by the static pressure of the pressurized gas, moving unit MUT2 is supported by levitation in a non-contact manner, via a clearance of several µm between gas hydrostatic bearing 141 and guide surface 257a. Further, the pressurized gas from the outlet on the side surface of gas hydrostatic bearing 141 blows on guide surface 257b and by the static pressure of the pressurized gas, a clearance of around several µm is maintained between gas hydrostatic bearing 141 and guide surface 257b. More specifically, in this case, guide surface 257b also functions as a yaw guide to moving unit MUT2.

Vertical movement guide 57B is driven by shaft motor 68B, between the lower moving limit position shown in FIG. 5 where guide surface 257a becomes in plane with guide surface 253c and the upper moving limit position shown in FIG. 6 where guide surface 257a becomes in plane with guide surface 253a.

As is obvious from the description so far, in the embodiment, in the state in FIG. 5 where vertical movement guides 55A, 57A, 55B, and 57B are all positioned at the lower moving limit position, the height of guide surface 155a of vertical movement guide 55A, guide surface 157a of vertical movement guide 57A, and the second guide surface 153b of fixed guide 53A coincide with one another, while the height of guide surface 255a of vertical movement guide 55B, guide surface 257a of vertical movement guide 57B, and guide surface 253c of fixed guide 53B also coincide with one another. Accordingly, moving unit MUT2 can be reciprocally moved along the Y-axis direction from the moving limit position on the +Y side of vertical movement guides 55A and 57A to the moving limit position on the -Y side of vertical movement guides 55B and 57B.

Further, in the embodiment, in the state in FIG. 6 where vertical movement guides 55A, 57A, 55B, and 57B are all positioned at the upper moving limit position, the height of guide surface 155a of vertical movement guide 55A, guide surface 157a of vertical movement guide 57A, and the first guide surface 153a of fixed guide 53A coincide with one another, while the height of guide surface 255a of vertical movement guide 55B, guide surface 257a of vertical movement guide 57B, and guide surface 253a of fixed guide 53B also coincide with one another.

On the +X side surface and -Y side surface of vertical movement guide 55A, on the +X side surface and +Y side surface of vertical movement guide 57A, on the -X side surface and -Y side surface of vertical movement guide 55B, and on the -X side surface and -Y side surface of vertical movement guide 57B, a gas hydrostatic bearing (not shown) is arranged on each of the surfaces, and by the gas blowing onto the surface opposing the gas hydrostatic bearing, each of the vertical movement guides is vertically driven in a non-contact manner by the corresponding shaft motors with respect to fixed guide 53A and 53B.

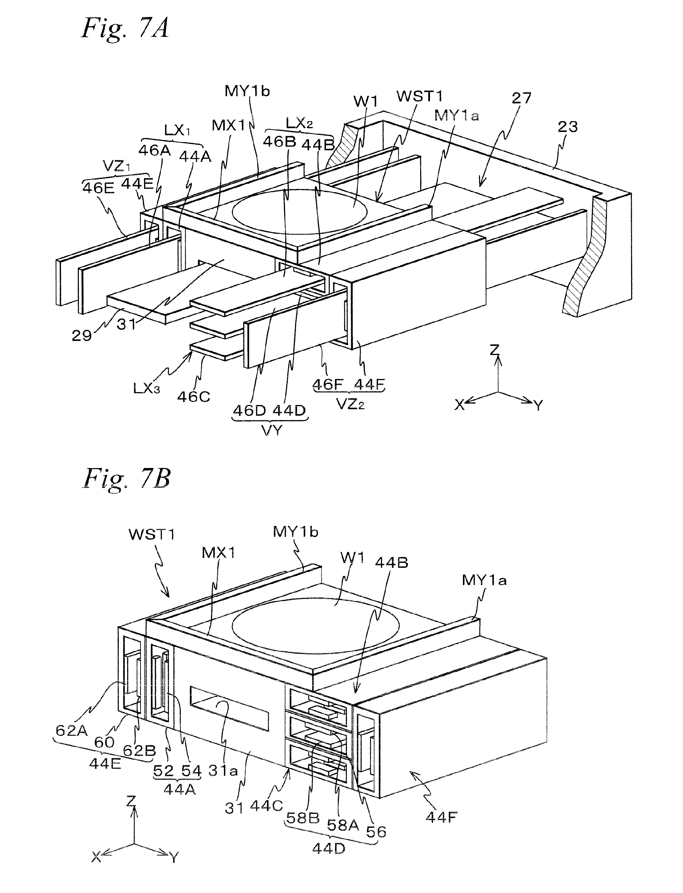

As is shown in FIG. 7A where stator unit 27 configuring one of the moving units, moving unit MUT1, is shown along with wafer stage WST1, stator unit 27 is composed of six stators 46A, 46B, 46C, 46D, 46E, and 46F whose longitudinal direction is in the X-axis direction, and a support plate 29 whose longitudinal direction is in the X-axis direction.

Stator 46A whose longitudinal direction is the X-axis direction, has a housing that has both one end and the other end in the longitudinal direction fixed to frame 23 so that the housing is substantially parallel to the XZ plane, and a plurality of armature coils (not shown) disposed at a predetermined distance in the X-axis direction inside the housing.

Stators 46B, 46D, and 46C whose longitudinal direction is the X-axis direction, each have both one end and the other end fixed to frame 23, and the stators are installed at a position a predetermined distance away from stator 46A on the +Y side, in a manner so that the stators are arranged sequentially from the top to the bottom at a predetermined distance and are also substantially parallel to the XY plane. Of these stators, stator 46B has a housing that has both one end and the other end in the longitudinal direction fixed to frame 23, and a plurality of armature coils (not shown) disposed at a predetermined distance in the X-axis direction inside the housing. Further, stator 46D has a housing whose longitudinal direction is in the X-axis direction and is arranged below stator 46B in a substantially parallel manner, and one or a plurality of armature coils disposed inside the housing, such as for example, a pair of a rectangular-shaped armature coils extending narrowly in the X-axis direction, disposed in the Y-axis direction at a predetermined distance. Further, stator 46C is configured similarly to stator 46B, and is disposed substantially parallel to stator 46D below stator 46D. In this case, stator 46B and stator 46C are disposed vertically symmetric, with stator 46D as the center.

Stator 46E has a housing whose longitudinal direction is in the X-axis direction and is arranged a predetermined distance away on the -Y side of stator 46A in a substantially parallel manner, and one or a plurality of armature coils disposed inside the housing, such as for example, a pair of a rectangular-shaped armature coils extending narrowly in the X-axis direction, disposed in the Z-axis direction at a predetermined distance. Further, stator 46F has a housing whose longitudinal direction is in the X-axis direction and is arranged on the +Y side of stators 46B to 46D so that the housing is parallel to the XZ plane, and one or a plurality of armature coils disposed inside the housing, such as for example, a pair of a rectangular-shaped armature coils extending narrowly in the X-axis direction, disposed in the Z-axis direction at a predetermined distance.

Support plate 29 is composed of a plate-shaped member whose one end and the other end in the longitudinal direction is fixed to frame 23, and is arranged so that the plate-shaped member is substantially parallel to the XY plane and extending in the X-axis direction. Support plate 29 is a plate-like member with high rigidity, and as it will be described later in the description, the plate is used to support the weight of wafer stage WST1 (maintain the Z position of wafer stage WST1).

Referring back to FIG. 2, the other staler unit 127 is configured in a similar manner as stator unit 27 described above.

As is shown in FIG. 7B, one of the wafer stages, wafer stage WST1, is equipped with a cuboid wafer stage main body 31, and a group of movers fixed to wafer stage main body 31 at a predetermined position relation, integrally, and has a rough cuboid shape as a whole. Of these parts, wafer stage main body 31 is made of a material lightweight and with high rigidity, such as a metal-matrix composite (a composite of metal and ceramics (a material that uses aluminum alloy or metalluragical silicon as a matrix material, compounded with a various types of ceramics reinforcements)).

As is shown in FIG. 7B, the group of movers that constitute wafer stage WST1 include six movers; movers 44A, 44B, 44C, 44D, 44E, and 44F.

As is shown in FIG. 7B, mover 44A is fixed to wafer stage main body 31 on the side surface on the -Y side, and mover 44A has a yoke 52 that has a rectangular YZ section and a tube-like shape in general, and a plurality of field magnets 54 disposed inside yoke 52 on the lateral opposing surfaces at a predetermined distance along the X-axis direction. In this case, the adjacent field magnets 54 in the X-axis direction and the opposing field magnets 54 in the Z-axis direction each have a reversed polarity. Therefore, in the space inside yoke 52, an alternating magnetic field (the direction of the magnetic field is in the +Y direction and the -Y direction) is formed in the X-axis direction.

Then, in the state shown in FIG. 2 where wafer stage WST1 is engaged with the group of stators in stator unit 27 and support plate 29, stator 46A described earlier is inserted into the inner space of yoke 52, and by the Lorentz force generated by the electromagnetic interaction between the current that flows in the plurality of the armature coils that constitute stator 46A and the alternating magnetic field in the inner space of yoke 52 of mover 44A, a drive force in the X-axis direction acts on Y mover 44A, and mover 44A is driven along stator 46A in the X-axis direction. More specifically, in the embodiment, stator 46A and mover 44A constitute an X-axis linear motor LX₁ composed of a moving magnet type Y-axis linear motor (refer to FIG. 7A).

Movers 44B, 44D, and 44C correspond to stators 46B, 46D, and 46C previously described, respectively, and according to the arrangement of the stators, the movers are fixed to the side surface of wafer stage main body 31 on the +Y side, in a state vertically stacked in the order of movers 44B, 44D,and 44C.

More specifically, although the direction of the magnetic flux of the alternating field formed inside the yoke is in the +Z direction or the -Z direction, the configuration or the like of mover 44B is basically the same as mover 44A previously described. Accordingly, in the state shown in FIG. 2 where wafer stage MST1 is engaged with the group of stators in stator unit 27 and support plate 29, a drive force in the X-axis direction acts on mover 44B, and mover 44B is driven along stator 46B, in the X-axis direction. More specifically, in the embodiment, stator 46B and mover 44B constitute an X-axis linear motor LX₂ composed of a moving magnet type linear motor (refer to FIG. 7A).

Although the direction of the magnetic flux of the alternating field formed inside the yoke is in the +Z direction or the -Z direction, the configuration or the like of mover 44C is basically the same as mover 44A previously described. Accordingly, in the state shown in FIG. 2 where wafer stage WST1 is engaged with the group of stators in stator unit 27 and support plate 29, a drive force in the X-axis direction acts on mover 44C, and mover 44C is driven along stator 46C, in the X-axis direction. More specifically, in the embodiment, stator 46C and mover 44C constitute an X-axis linear motor LX₃ composed of a moving magnet type linear motor (refer to FIG. 7A).

In the embodiment, by expressing each of the drive force of X-axis linear motors LX₂ and LX₃ as f, and the drive force of X-axis linear motor LX₁ as 2xf, wafer stage WST1 can be driven in the X-axis direction (a substantially centroid drive) with respect to the group of stators in stator unit 27 and support plate 29. Further, by making the drive forces generated by X-axis linear motors LX₂ and LX₃ different, wafer stage WST1 can be finely driven in the rotation direction around the Y-axis (the rolling direction), and also by making the resultant force of the drive forces generated by X-axis linear motors LX₂ and LX₃ and the drive force generated by X-axis linear motor LX₂ different, wafer stage MST1 can be finely driven in the rotation direction around the Z-axis (the yawing direction).

As is shown in FIG. 7B, mover 44D is equipped with a frame-shaped member 56 consisting of a magnetic body that has a rectangular frame-shaped XZ section, and a pair of permanent magnets 58A and 58B extending narrowly in the X-axis direction that are each fixed to the vertical opposing surfaces (the upper surface and lower surface) on the inner side of frame-shaped member 56. Permanent magnet 58A and permanent magnet 58B have a reversed polarity. Accordingly, between permanent magnet 58A and permanent magnet 58B, a magnetic field is generated whose direction of magnetic flux is in the +Z direction (or the -Z direction). Then, in the state shown in FIG. 2 where wafer stage WST1 is engaged with the group of stators in stator unit 27 and support plate 29, stator 46D is inserted between permanent magnets 58A and 58B, and half the section substantially on the inner side of each of the pair of armature coils that constitute stator 46D is included in the magnetic field between permanent magnets 58A and 58B described above. Accordingly, by supplying current to each armature coil in the pair so that the current flows in opposite directions, the current direction in each armature coil in the magnetic field above becomes the +X direction (or the -X direction), and by the Lorentz force generated by the electromagnetic interaction between the current that flows in each armature coil and the magnetic field between permanent magnets 58A and 58B, mover 44D (and wafer stage WST1) is finely driven in the Y-axis direction with respect to stator 46D. More specifically, stator 46D and mover 44D constitute a Y-axis fine movement motor VY that finely drives wafer stage WST1 in the Y-axis direction (refer to FIG. 7A).

Mover 44E corresponds to stator 46E, and is equipped with a frame-shaped member 60 consisting of a magnetic body that has a rectangular frame-shaped YZ section, and a pair of permanent magnets 62A and 62B extending narrowly in the X-axis direction that are each arranged on a pair of opposing surfaces (the surfaces on both the +Y and-Y sides) on the inner side of frame-shaped member 60. Permanent magnet 62A and permanent magnet 62B have a reversed polarity. Accordingly, between permanent magnet 62A and permanent magnet 62B, a magnetic field is generated whose direction of magnetic flux is in the +Y direction (or the -Y direction). Then, in the state shown in FIG. 2 where wafer stage WST1 is engaged with the group of stators in stator unit 27 and support plate 29, stator 46E is inserted between permanent magnets 62A and 62B, and half the section substantially on the inner side of each of the pair of armature coils that constitute stator 46E is included in the magnetic field between permanent magnets 62A and 62B described above. Accordingly, by supplying current to each armature coil in the pair so that the current flows in opposite directions, the current direction in each armature coil in the magnetic field above becomes the +X direction (or the -X direction), and by the Lorentz force generated by the electromagnetic interaction between the current that flows in each armature coil and the magnetic field between permanent magnets 62A and 62B, mover 44E (and wafer stage WST1) is finely driven in the Z-axis direction with respect to stator 46E.

More specifically, in the embodiment, mover 44E and stator 46E constitute a first Z-axis fine movement motor VZ₁ that finely drives wafer stage WST1 in the Z-axis direction (refer to FIG. 7A).

As is shown in FIG. 7B, mover 44F is arranged on the +Y side of movers 44B, 44D, and 44C, and the configuration is similar to mover 44E. And, in the state shown in FIG. 2 where wafer stage WST1 is engaged with the group of stators in stator unit 27 and support plate 29, mover 44F and stator 46F constitute a second Z-axis fine movement motor VZ₂ that finely drives wafer stage WST1 (and mover 44F) in the Z-axis direction with respect to stator 46F (refer to FIG. 7A).

In the case of the embodiment, by making the first Z-axis fine movement motor VZ₁ and the second Z-axis fine movement motor VZ₂ generate the same drive force, wafer stage WST1 can be finely driven in the Z-axis direction, whereas by making each Z-axis fine movement motor generate a different drive force, wafer stage WST1 can be finely driven in a rotation direction around the X-axis (the pitching direction).

As is described above, in the embodiment, Y-axis fine movement motor VY, X-axis linear motors LX₁ to LX₃, and the first Z-axis fine movement motor VZ₁ and the second Z-axis fine movement motor VZ₂ constitute a six degrees of freedom drive mechanism, which drives wafer stage WST1 in directions of six degrees of freedom with respect to stator unit 27.

Although the description falls out of sequence, in wafer stage main body 31, a through hole 31a is formed along the X-axis direction as is shown in FIG. 7B, and in the state shown in FIG. 2 where wafer stage WST1 is engaged with the group of stators in stator unit 27 and support plate 29, support plate 29 is in a state inserted into through hole 31a. Inside through hole 31a, a deadweight canceller (not shown) is arranged. The deadweight canceller has a cylinder section and a piston section, and is set at a positive pressure by the gas supplied inside the cylinder section. And, the positive pressure inside the cylinder section supports the entire wafer stage WST1 in a state relatively movable with respect to support plate 29.

Support plate 29 and the deadweight canceller do not necessarily have to be arranged, and in the case support plate 29 and the deadweight canceller are not arranged, the deadweight of wafer stage WST1 can be supported by making the first Z-axis fine movement motor VZ₁ and the second Z-axis fine movement motor VZ₂ generate a force in the Z-axis direction that balances with the deadweight of wafer stage WST1.

The other wafer stage, wafer stage WST2 is configured similarly to wafer stage WST1 described above. Accordingly, as is shown in FIG. 2, in the state where wafer stage WST2 is engaged with the group of stators in stator unit 127 and the support plate, wafer stage WST2 is derivable in directions of six degrees of freedom by the group of movers in wafer stage WST2 and the group of stators in stator unit 127, as in the case of wafer stage WST1.

Further, also in the wafer stage main body that constitutes wafer stage WST2, a through hole is formed corresponding to the support plate as in wafer stage main body 31 on the wafer stage WST1 side, and in the state where wafer stage WST2 is engaged with the group of stators in stator unit 127 and the support plate, the entire wafer stage WST1 is supported in a state relatively movable with respect to the support plate by the deadweight canceller arranged in the through hole section.

As is shown in FIG. 7B, on the upper surface (the +Z side surface) of one of the wafer stages, wafer stage WST1, an X movable mirror MX1 extending in the Y-axis direction is arranged on one end (the end section on the +X side) in the X-axis direction, a Y movable mirror MY1a extending in the X-axis direction is arranged on one end (the end section on the +Y side) in the Y-axis direction, and a Y movable mirror MY1b extending in the X-axis direction is arranged on the other end (the end section on the -Y side) in the Y-axis direction. And, on each of the reflection surfaces of these movable mirrors MX1, MY1a, and MY1b, interferometer beams (measurement beams) from interferometers of each measurement beam constituting an interferometer system, which will be described later, are projected, and the lights reflected off the reflection surfaces are received by the interferometers, which measure the displacement of each of the reflection surfaces of the movable mirrors from a reference position (a fixed mirror is normally arranged as a reference plane on the side surface of the projection optical system or the side surface of the alignment system), and by this operation, the two-dimensional position of moving unit MUT1 (wafer stage WST1) is measured. Further, on the upper surface of wafer stage WST1, wafer M1 is fixed by electrostatic suction or by vacuum chucking via a wafer holder (not shown). In FIG. 1, however, only movably mirrors MY1a and MY1b for measuring the position in the Y-axis direction are shown as the movable mirrors on the wafer stage WST1 side.

As is shown in FIG. 2, on the upper surface (the +Z side surface) of the other wafer stage, wafer stage WST2, an X movable mirror MX2 extending in the Y-axis direction is arranged on one end (the end section on the +X side) in the X-axis direction, a Y movable mirror MY2a extending in the X-axis direction is arranged on one end (the end section on the +Y side) in the Y-axis direction, and a Y movable mirror MY2b extending in the X-axis direction is arranged on the other end (the end section on the -Y side) in the Y-axis direction. And, on each of the reflection surfaces of these movable mirrors MX2, MY2a, and MY2b, interferometer beams (measurement beams) from interferometers of each measurement beam constituting an interferometer system, which will be described later, are projected, and the lights reflected off the reflection surfaces are received by the interferometers, which measure the displacement of each of the reflection surfaces of the movable mirrors from a reference position, and by this operation, the two-dimensional position of wafer stage WST2 is measured. Further, on the upper surface of wafer stage WST2, wafer W2 is fixed by electrostatic suction or by vacuum chucking via a wafer holder (not shown). In FIG. 1, however, only movably mirrors MY2a and MY2b for measuring the position in the Y-axis direction are shown as the movable mirrors on the wafer stage WST2 side.

In the embodiment, the magnitude and the direction of the current supplied to each of the armature coils that make up each of the motors described above constituting stage unit 20 is controlled by main controller 50 in FIG. 1. Accordingly, the magnitude and direction of the drive force that each motor generates is arbitrarily controlled.

As is shown in FIGS. 1 and 2, alignment system ALG is arranged at a position a predetermined distance away from projection optical system PL, on the +Y side and the -X side (that is, at a position diagonally away). As alignment system ALG, for example, an alignment sensor of an FIA (Field Image Alignment) system is used, which is a type of an image-forming alignment sensor based on an image-processing method. Alignment system ALG is configured including a light source (such as a halogen lamp) and an image-forming optical system, an index plate where index marks that will be the detection reference are formed, a pick-up device (a CCD), and the like. In alignment system ALG, the light source irradiates a broadband detection beam on the mark subject to detection, and the reflection light from the vicinity of the mark is received by the CCD via the image-forming optical system, along with the light from the index. Then, the image of the mark is formed on the imaging plane of the CCD along with the image of the index. And, by performing a predetermined image processing on the image signals (imaging signals) from the CCD, the position of the marks is measured whose reference is the center of the index marks, serving as the detection center.

In the embodiment, alignment system ALG is used to measure the position information of fiducial marks on a fiducial mark plate (not shown) on wafer stages MST1 and MST2, the position information of alignment marks on the wafer, and the like. An alignment controller (not shown) performs A/D conversion on the image signals from alignment system ALG, and the digitalized waveform signals are processed to detect the position of the marks whose reference is the index center. The information on the mark position is sent from the alignment controller (not shown) to main controller 50.

Next, the interferometer system that measures the position of wafer stages MST1 and WST2 will be briefly described.

In FIG. 1, on the reflection surface of movable mirror MY1b on wafer stage WST1, an interferometer beam (a measurement beam) is irradiated from a Y interferometer 116, in the direction parallel to the Y-axis passing through the optical axis of projection optical system PL from Y interferometer 116. Similarly, on the reflection surface of movable mirror MY2a on wafer stage WST2, an interferometer beam (a measurement beam) is irradiated from a Y interferometer 118, in the direction parallel to the Y-axis passing through the detection center (the center of the index mark) of alignment system ALG from interferometer 118. And, in Y-axis interferometers 116 and 118, by receiving the lights reflected off movable mirrors MY1b and MY2a, respectively, the relative displacement from the reference position of each reflection surface is measured, and the position of wafer stage WST1 and WST2 in the Y-axis direction is measured.

In this case, Y-axis interferometers 116 and 118 are both multi-axis interferometers, and other than measuring the position information of wafer stage WST1 and MST2 in the Y-axis direction, Y-axis interferometers 116 and 118 can also measure pitching (rotation around the X-axis (θx rotation)) and yawing (rotation in the θz direction). The output values of each measurement axis can be measured independently.

Further, on the reflection surface of movable mirror MX1 on wafer stage WST1, an interferometer beam (a measurement beam), which passes through the optical axis of projection optical system PL and perpendicularly crosses the interferometer beam from Y interferometer 116, is irradiated from an X interferometer (not shown). Similarly, on the reflection surface of movable mirror MX2 on wafer stage WST2, an interferometer beam (a measurement beam), which passes through the detection center (the center of the index mark) of alignment system ALG and perpendicularly crosses the interferometer beam from Y interferometer 118, is irradiated from an X interferometer (not shown). And, in each of the X-axis interferometers above, by receiving the lights reflected off movable mirrors MX1 and MX2, respectively, the relative displacement from the reference position of each reflection surface is measured, and the position of wafer stage WST1 and WST2 in the X-axis direction is measured. In this case, the X-axis interferometers are multi-axis interferometers, and other than measuring the position information of wafer stage WST1 and WST2 in the X-axis direction, X-axis interferometers can also measure rolling (rotation around the Y-axis (θy rotation)) and yawing (rotation in the θz direction). The output values of each measurement axis can be measured independently.

As is described, in the embodiment, a total of four interferometers; the two X-axis interferometers and Y-axis interferometers 116 and 118, constitute a wafer interferometer system that controls the XY two-dimensional coordinate position of wafer stages MST1 and WST2. The measurement values of each of the interferometers that make up the system are sent to main controller 50.

In the description below, the X-axis interferometer that emits the interferometer beam passing through the detection center (the center of the index mark) of alignment system ALG and perpendicularly crosses the interferometer beam from Y interferometer 118 will be referred to as an alignment X-axis interferometer, and the X-axis interferometer that emits the interferometer beam which passing through the optical axis of projection optical system PL and perpendicularly crosses the interferometer beam from Y interferometer 116 will be referred to as an exposure X-axis interferometer.

Main controller 50 controls the position of wafer stages WST1 and WST2 within the XY plane with high precision, without any of the so-called Abbe errors, based on the measurement values of exposure X-axis interferometer and Y interferometer 116 on exposure, which will be described later, whereas, on wafer alignment, which will also be described later, main controller 50 controls the position of wafer stages WST1 and WST2 within the XY plane with high precision, without any of the so-called Abbe errors, based on the measurement values of alignment X-axis interferometer and Y interferometer 118.

However, in the embodiment, moving units MUT1 and MUT2 do not constantly maintain the position relation shown in FIGS. 1, 2, and the like, and as it will be described later, wafer stages WST1 and WST2 will be interchanged, and the case may occur where the interferometer beams will not irradiate the movable mirrors on wafer stage MST2. By taking such points into consideration, linear encoders (not shown) that can constantly measure the position information of moving unit MUT2 in the Y-axis direction are arranged at predetermined positions.

Then, on the interchange of wafer stage WST1 and WST2 by main controller 50, when the position of wafer stage WST2 cannot be measured by the Y-axis interferometers, main controller 50 controls the Y position of wafer stage WST2 (moving unit MUT2) based on the position information of the Y-axis direction measured by the linear encoders.

Further, in the embodiment, a case where the interferometer beams from the X-axis interferometers will not irradiate the movable mirrors on wafer stages WST1 and WST2 when wafer stages WST1 and WST2 are moving in the Y-axis direction may occur.

Therefore, when the interferometer beams from any of the interferometers that could not perform measurement since the interferometer beams did not irradiate the movable mirrors for some reason start to irradiate the movable mirrors of wafer stages WST1 and WST2 again, main controller 50 resets (or presets) the measurement values of the interferometer that could not perform measurement.

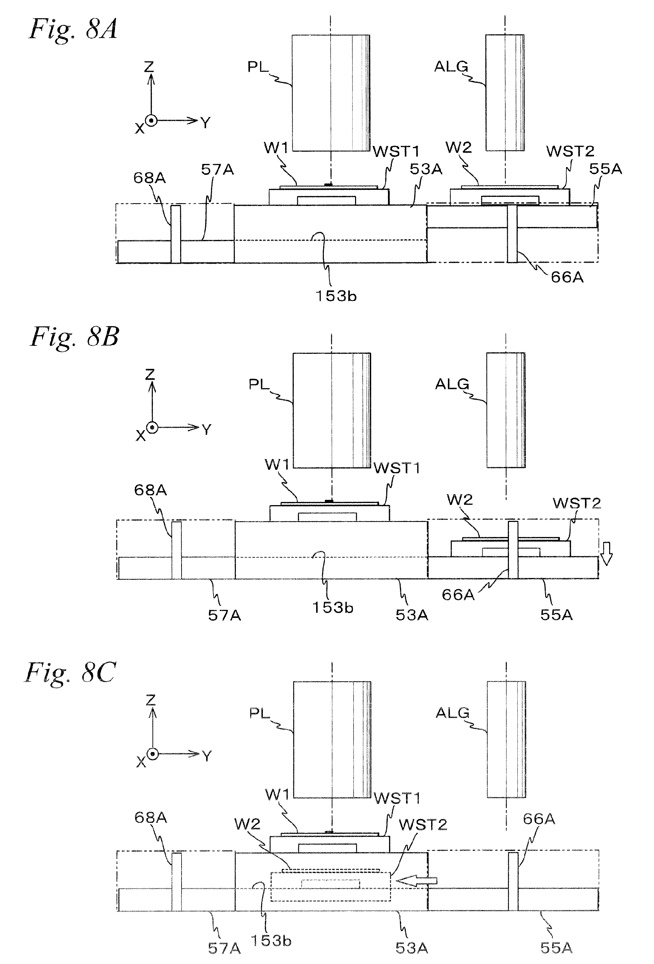

Next, a series of exposure sequences that uses the exposure apparatus configured in the manner described above will be described, referring to FIGS. 8A to 10C.

FIG. 8A shows the state where in parallel with the exposure operation of wafer W1 on wafer stage WST1 via projection optical system PL under the control of main controller 50, wafer alignment operation using alignment system ALG is being performed on wafer M2 on wafer stage WST2 (FIG. 8A corresponds to the state shown in FIG. 1)

Prior to the state in FIG. 8A, when wafer stage WST2 (and moving unit MUT2) is at a predetermined loading position (in the vicinity of the alignment position), a wafer loader (not shown) performs unloading of the wafer mounted on wafer stage WST2 that has been exposed and loading of a new wafer W2 (that is, wafer exchange) onto wafer stage WST2.

On the alignment operation referred to above, main controller 50 detects the position information of alignment marks (sample marks) arranged in a specific plurality of shot areas (sample shot areas) on wafer W2, while controlling the position of wafer stage WST2 within the XY plane based on the measurement values of Y interferometer 118 and alignment X-axis interferometer described above. On this wafer alignment, main controller 50 drives moving unit MUT2 (wafer stage WST2) in the Y-axis direction with long strokes using Y-axis linear motors 45A and 145A previously described, and also finely drives wafer stage WST2 in the X, Y, Z, θx, θy, and θz directions via the six degrees of freedom drive mechanism previously described that constitutes moving unit MUT2. Further, when main controller 50 drives wafer stage WST2 in the X-axis direction with long strokes, main controller 50 uses the three X-axis linear motors that make up the six degrees of freedom drive mechanism of moving unit MUT2.

Next, based on the detection results of the position information and the designed position coordinates of the specific shot areas (or sample marks) described above, main controller 50 performs wafer alignment by the EGA (Enhanced Global Alignment) method in order to obtain the arrangement coordinates of all the shot areas on wafer W2 by statistical calculation using the least square method, as is disclosed in, for example, Kokai (Japanese Unexamined Patent Application Publication) No. 61-44429, and the corresponding U.S. Patent No. 4,780,617, and the like. As long as the national laws in designated states (or elected states), to which this international application is applied, permit, the above disclosures of the publication and the U.S. Patent are incorporated herein by reference.

Further, in this case, around the time when the position information of the sample marks is detected, main controller 50 detects the position information of a first fiducial mark on the fiducial mark plate (not shown) on wafer stage WST2. Then, main controller 50 converts the arrangement coordinates of all the shot areas on wafer W2 obtained in advance into position coordinates whose origin is set to the position of the first fiducial mark.

In the manner described above, wafer exchange and wafer alignment is executed on the wafer stage WST2 side. In parallel with the wafer exchange and the wafer alignment, on the wafer stage WST1 side, an exposure operation by the step-and-scan method is performed under the control of main controller 50 where a stepping operation between shots in which wafer stage WST1 is moved to the acceleration starting position for exposure of each shot area on wafer W1 mounted on wafer stage WST1 based on the wafer alignment results that has been performed earlier, and a scanning exposure operation where the pattern formed on reticle R is transferred onto the shot areas subject to exposure on wafer W1 via projection optical system PL by relatively scanning reticle R (reticle stage RST) and water W1 (wafer stage WST1) in the Y-axis direction are repeated.

Prior to starting the exposure operation by the step-and-scan method referred to above, main controller 50 measures a pair of second fiducial marks on the fiducial mark plate (not shown) on wafer stage WST1 and a pair of reticle alignment marks on reticle R using a reticle alignment system (not shown), while controlling the position of wafer stage WST1 based on the measurement values of Y-axis interferometer 116 and exposure X-axis interferometer. Then, based on the measurement results (the position relation between the projection center of the reticle pattern and the pair of second fiducial marks (the position relation between the second fiducial marks and the first fiducial mark referred to earlier is known) on the fiducial mark plate) and the results of the wafer alignment performed in advance (the position coordinates of each of the shot areas on wafer W1, with the first fiducial mark serving as a reference), main controller 50 moves wafer stage WST1 to the acceleration starting position for exposing each of the shot areas on wafer W1.

Because the position relation between the projection center of the reticle pattern and the pair of second fiducial marks on the fiducial mark plate is measured, using the reticle alignment system prior to the exposure operation in the manner described above, even if a situation where the interferometers cannot measure the position of the wafer stage occurs after wafer alignment until the beginning of exposure, it will not cause any inconvenience.

On the exposure operation by the step-and-scan method described above, main controller 50 drives moving unit MUT1 (wafer stage WST1) in the Y-axis direction with long strokes using Y-axis linear motors 33A and 33B previously described, and also finely drives wafer stage WST1 in the X, Y, Z, θx, θy, and θz directions via the six degrees of freedom drive mechanism previously described that constitutes moving unit MUT1. Further, when main controller 50 drives wafer stage WST1 in the X-axis direction with long strokes, main controller 50 uses the three X-axis linear motors LX₁ to LX₃ that make up the six degrees of freedom drive mechanism of moving unit MUT1.

Since the procedure of the exposure operation itself is the same as in a typical scanning stepper, a more detailed description will be omitted.

In the wafer alignment operation performed on the wafer on wafer stage MST2 and the exposure operation performed on the wafer on wafer stage WST1 described above, normally, the wafer alignment operation is completed earlier. Therefore, after wafer alignment has been completed, while exposure operation of the wafer on wafer stage MST1 is still being performed, main controller 50 performs the interchange of the wafer stage in parallel, and moves moving unit MUT2 containing wafer stage WST2 to the -Y side of moving unit MUT1 by masking moving unit MUT2 pass under moving unit MUT1.

To be more specific, main controller 50 drives vertical movement guides 55A and 55B downward via shaft motors 66A and 66B, from the upper end moving position shown in FIG. 8A to the lower end moving position shown in FIG. 8B. And, by the downward drive of vertical movement guides 55A and 55B, moving unit MUT2 is driven downward, and the pair of Y movers 133A and 133B installed in moving unit MUT2 becomes engaged with Y stators 45B and 145B, respectively.

Further, when moving unit MUT2 moves downward as is described above, the interferometer beams that have been irradiating movable mirrors MX2 and MY2 will no longer irradiate the movable mirrors. Therefore, just when moving unit MUT2 finishes the downward movement, the encoder previously described simultaneously begins to perform the position measurement of moving unit MUT2 in the Y-axis direction.

When vertical movement guides 55A and 55B are lowered to the lower end moving position as is described, and vertical movement guides 57A and 57B are also at the lower end moving position as is shown in FIG. 8B, then the height position of guide surface 153b of fixed guide 53A coincides with guide surface 155a of vertical movement guide 55A and guide surface 157a of vertical movement guide 57A, and also the height position of guide surface 253a of fixed guide 53B coincides with guide surface 255a of vertical movement guide 55B and guide surface 257a of vertical movement guide 57B (refer to FIG. 5).

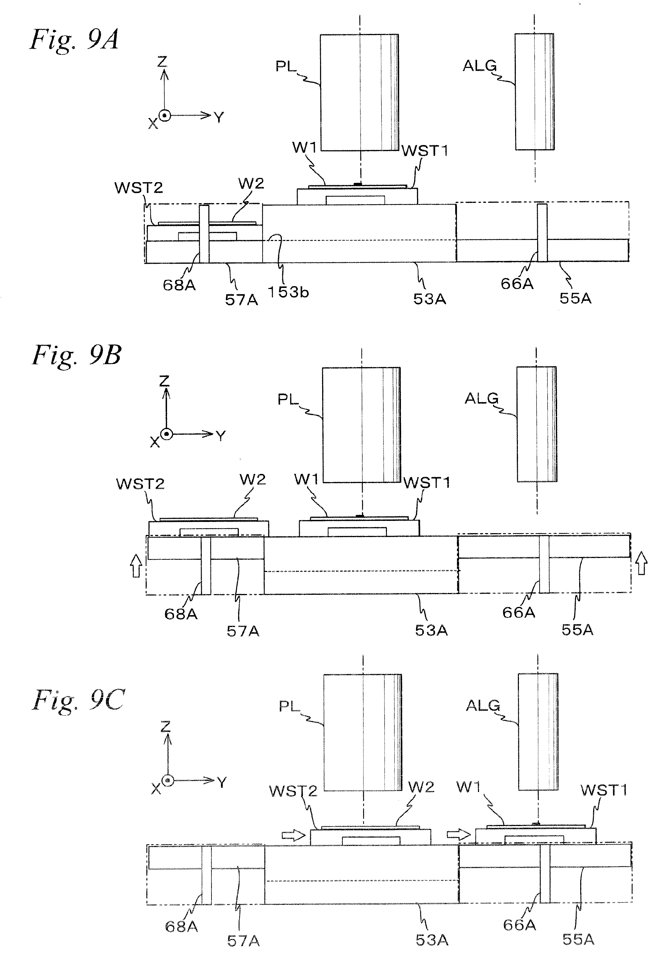

Therefore, main controller 50 drives Y-axis linear motors 45B and 145B while monitoring the measurement values of the encoder previously described, and drives moving unit MUT2 from the position shown in FIG. 8B on vertical movement guides 55A and 55B to the position shown in FIG. 9A on vertical movement guides 57A and 57B, via the position shown in FIG. 8C on fixed stators 53A and 53B (the position under moving unit MUT1).

Next, main controller 50 drives vertical movement guides 57A and 57B up toward the upper end moving position shown in FIG. 9B via shaft motors 68A and 68B. However, at this point, exposure of wafer W1 is still being performed on the wafer stage WST1 side and the position of wafer stage WST1 is being measured by Y-axis interferometer 116 and exposure X-axis interferometer. Accordingly, main controller 50 drives vertical movement guides 57A and 57B up to the position slightly below the position shown in FIG. 9B and keeps the guides at the position until the exposure operation on the wafer stage WST1 side is completed, so that the interferometer beams from interferometer 116 are not cut off by the position change of wafer stage WST2 that occurs with the upward drive of vertical movement guides 57A and 57B.

Then, when the exposure operation of the wafer stage WST1 side is completed, main controller 50 drives vertical movement guides 57A and 57B further upward to the upper end moving position shown in FIG. 9B via shaft motors 68A and 68B. By this movement, wafer stage WST2 rises to the height position shown in FIG. 9B, and during this movement, the interferometer beams from interferometer 116 moves away from movable mirror MY1b on wafer stage WST1 and at the same time begins to irradiate movable mirror MY2b on wafer stage WST2.

Then, prior to the interferometer beams from Y-axis interferometer 116 moving off movable mirror MY1b on wafer stage WST1, main controller 50 switches the interferometer that measures the position of wafer stage WST2 in the Y-axis direction to Y-axis interferometer 118 whose interferometer beams are irradiating movable mirror MY1a at this point. Further, main controller 50 also switches the measurement unit used for measuring the Y-axis position of wafer stage WST2 (moving unit MUT2) from the encoder to Y-axis interferometer 116.

At the point where the switching of the interferometers described above have been completed, vertical movement guides 55A and 55B are driven to the upper end moving position by shaft motors 66A and 66B, as is shown in FIG. 9B.

Next, main controller 50 drives Y-axis linear motor 45A and 145A, and Y-axis liner motors 33A and 33B, respectively, and moves both wafer stage WST2 (moving unit MUT2) and wafer stage WST1 (moving unit MUT1) in the +Y direction as is shown in FIG. 9C. To be more specific, main controller 50 moves wafer stage WST2 until the fiducial mark plate is positioned under projection optical system PL, and moves wafer stage WST1 to the wafer exchange position.

Then, on the wafer stage WST2 side where wafer stage WST2 is moved so that the fiducial mark plate is positioned under projection optical system PL, main controller 50 measures the pair of the second fiducial marks on fiducial mark plate on wafer stage WST2 and the pair of reticle alignment marks on reticle R using the reticle alignment system previously described, and after the measurement, the exposure operation of each shot area on wafer W2 by the step-and-scan method begins (refer to FIG. 9C), based on the measurement results and the results or wafer alignment referred to earlier.

In parallel with the exposure operation of wafer W2 on the wafer stage WST2 side described above, on wafer stage WST1 that has moved to the wafer exchange position, wafer W1 is unloaded via a wafer carrier unit (not shown), and the next wafer (in this case, the wafer is wafer W3) is loaded via the wafer carrier unit. And, after the wafer exchange, main controller 50 performs wafer alignment on wafer W3 on wafer stage WST1.

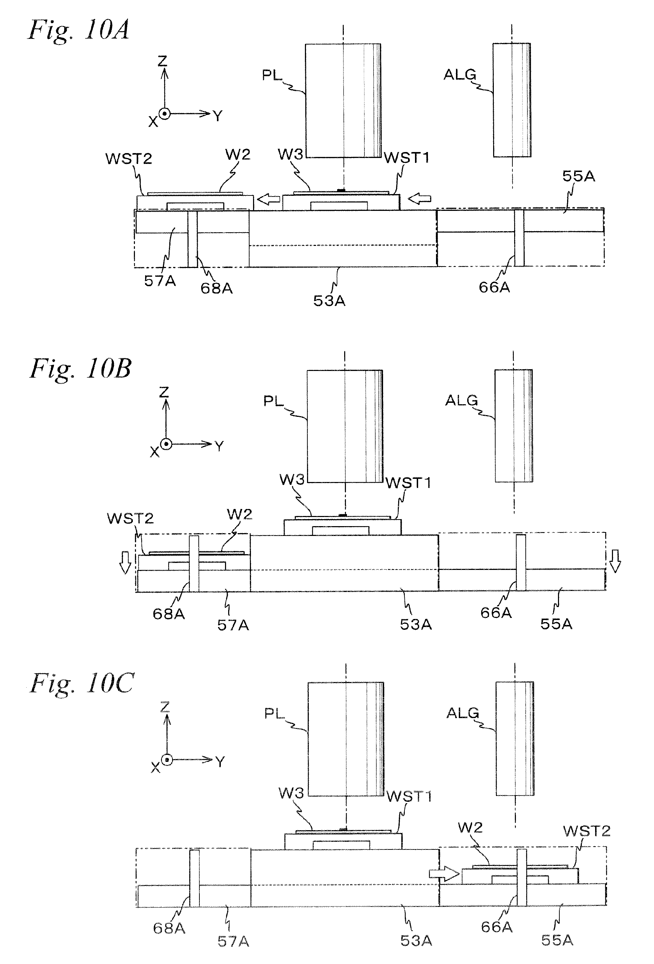

At the point where both the exposure operation on the wafer stage WST2 side and the alignment operation on the wafer stage WST1 side have been completed in the manner described above, main controller 50 moves wafer stage WST2 (moving unit MUT2) and wafer stage WST1 (moving unit MUT1) in parallel, in the -Y direction (refer to FIG. 10A).

Then, as is shown in FIG. 10A, at the point where wafer stage WST2 is positioned on vertical movement guides 57A and 57B at the upper end moving position, main controller 50 drives vertical movement guides 57A and 57B downward, as is shown in FIG. 10B. And by this downward drive, the interferometer beams from interferometer 116 that has been irradiating movable mirror MY2b on wafer stage WST2 moves away from movable mirror MY2b, and at begins to irradiate movable mirror MY1b on wafer stage WST1. Therefore, main controller 50 switches the interferometer that measures the Y position of wafer stage WST1 to Y-axis interferometer 116. Prior to the switching, the interferometer beams from the exposure X-axis interferometer irradiate movable mirror MX1 on wafer stage WST1, and the X position of wafer stage MST1 is measured by the exposure X-axis interferometer.

Accordingly, after switching the Y-axis interferometers described above, the position of wafer stage WST1 within the XY plane is measured by the exposure X-axis interferometer and Y-axis interferometer 116.

Then, on the wafer stage WST1 side, the exposure operation of wafer W3 begins similarly as is previously described.

Meanwhile, after driving vertical movement guides 57A and 57B downward to the lower end position shown in FIG. 10B, main controller uses the encoder for measuring the position of moving unit MUT2 in the Y-axis direction. With the downward drive of vertical movement guides 57A and 57B, Y movers 133A and 133B of movement unit MUT2 becomes engaged with Y stators 45B and 145B.

Almost simultaneously with the downward drive of driving vertical movement guides 57A and 57B, main controller 50 also drives vertical movement guides 55A and 55B downward from the upper end moving position in FIG. 10A to the lower end position shown in FIG. 10B.

Then, at the point where both vertical movement guides 55A and 55B and vertical movement guides 57A and 57B have been driven downward to the lower end position, main controller 50 moves moving unit MUT2 (wafer stage WST2) in the +Y direction using Y-axis linear motors 45B and 145B, to the position shown in FIG. 10C passing through the position below moving unit MUT1 (wafer stage WST1). Furthermore, from the state shown in FIG. 10C, main controller 50 drives vertical movement guides 55A and 55B upward, which brings the guides back into the state shown in FIG. 8A. Also in this case, main controller 50 switches from the position measurement of wafer stage WST2 by the encoder to the position measurement by the interferometer.

Hereinafter, the parallel processing operation using both wafer stages WST1 and WST2 described above using FIGS. 8A to 10C is repeatedly performed.

As is obvious from the description so far, in exposure apparatus 10 of the embodiment, the drive system (33A, 33B, 133A, 133B, 35A, 35B, and 51) described earlier and main controller 50 configure an exchange unit. Further, the elevator units EU1 and EU3 configure a first vertical movement mechanism, and the elevator units EU2 and EU4 configure a second vertical movement mechanism.

As is described in detail above, according to exposure apparatus 10 of the embodiment, the apparatus is equipped with an exchange unit (33A, 33B, 133A, 133B, 35A, 35B, 51, and 50) that switches both wafer stages WST1 and WST2 between the exposure operation of the wafer by projection optical system PL and the mark detection operation (wafer alignment operation) on the wafer by alignment system ALG in a procedure where of the two wafer stages WST1 and WST2, one of the wafer stages, wafer stage WST2 (specific stage) is positioned temporarily below the remaining wafer stage, wafer stage WST1. And, in the embodiment, the exchange unit makes it possible to perform a part of the interchange operation (exchange operation) of both wafer stages according to the procedure where the other stage, wafer stage WST2, which has completed the detection operation of the marks on the wafer by alignment system ALG in the vicinity of the second position (the position where alignment system ALG is disposed) is positioned temporarily below one of the stages, wafer stage WST1, in parallel with the exposure operation by projection optical system PL of the wafer on one of the stages, wafer stage WST1, positioned in the vicinity of the first position (the position where projection optical system PL is disposed).

Accordingly, the time required for the interchange can be reduced when compared with the case where the interchange operation of both stages begin when the exposure operation of the wafer on one of the stages has been completed, which makes it possible to improve the throughput of the exposure processing step where exposure of the wafer on the two wafer stages is alternately performed. Further, the interchange of the wafer stages can be achieved by simply moving each of the wafer stages along a path decided in advance, without performing the operation with uncertainty as in a mechanically grasping operation previously described. Therefore, the position alignment that was necessary when mechanically grasping operation was performed will not be required, and displacement of the wafer will not occur, so the exposure accuracy will not be reduced in particular. Further, since only one alignment system ALG will be required, the problems that occur due to having a plurality of alignment systems will also be resolved.

Further, according to exposure apparatus 10 of the embodiment, as is described using FIGS. 8A to 10C, when the two wafer stages, wafer stages WST1 and WST2 are alternately moved with respect to the first position (predetermined position) below projection optical system PL by the exchange unit described above, only one of the wafer stages of the two wafer stages, wafer stage WST2, is moved so as to be temporarily positioned below the other wafer stage MST1. That is, by wafer stage WST1 moving within a predetermined plane (the first plane previously described) and only wafer stage WST2 moving vertically and within the first plane, wafer stages WST1 and WST2 can be alternately moved to the first position. Accordingly, the two wafer stages, WST1 and WST2, can be alternately moved to the first position, for example, without the wirings and the like connected to wafer stages WST1 and WST2 being entangled.

In the embodiment above, the case has been described where a predetermined stage of one of the wafer stages, wafer stage WST2, is the specific stage, and the exchange procedure of the stages is employed where wafer stage WST2 is moved passing under the other wafer stage, wafer stage WST1. The present invention, however, is not limited to this. More specifically, the specific stage may be both wafer stage WST1 and wafer stage WST2. In such a case, the exchange unit can perform the exchange (interchange) of wafer stage WST1 and wafer stage WST2 according to a procedure where the wafer stage holding the wafer on which wafer alignment has been completed, which is the specific stage, is temporarily kept waiting under the remaining wafer stage where the exposure of the wafer is performed, and the apparatus may employ a structure where wafer stages WST1 and WST2 are circulated.

In the embodiment above, as illumination light IL, far ultraviolet light such as the KrF excimer laser beam, vacuum ultraviolet light such as the F₂ laser or the ArF excimer laser, or bright lines (such as the g-line or the i-line) in the ultraviolet region from an ultra high-pressure mercury lamp is used. The present invention, however, is not limited to this, and other vacuum ultraviolet lights can also be used such as the Ar₂ laser beam (wavelength 126 nm). Further, for example, illumination light IL is not limited to the laser beams emitted from the light sources described above, and a harmonic may also be used that is obtained by amplifying a single-wavelength laser beam in the infrared or visible range emitted by a DFB semiconductor laser or fiber laser, with a fiber amplifier doped with, for example, erbium (Er) (or both erbium and ytteribium (Yb)), and by converting the wavelength into ultraviolet light using a nonlinear optical crystal.

Furthermore, the present invention can also be applied to an exposure apparatus that uses an EUV light, an X-ray, or a charged particle beam such as an electron beam or an ion beam as illumination light IL. For example, in the case of an exposure apparatus that uses the charged particle beam, a charged particle beam optical system such as the electron optical system will constitute the exposure optical system. Besides such an apparatus, the present invention can also be applied to an immersion exposure apparatus that has a liquid filled in the space between projection optical system PL and the wafer whose details are disclosed in, for example, International Publication No. WO99/49504 or the like.

In the embodiment above, the case has been described where the present invention is applied to a scanning exposure apparatus based on the step-and-scan method. It is a matter of course, however, that the present invention is not limited to this. More specifically, the present invention can also be suitably applied to a reduction projection exposure apparatus based on a step-and-repeat method.

The exposure apparatus in the embodiment above can be made by incorporating the illumination optical system made up of a plurality of lenses and the projection optical system into the main body of the exposure apparatus, performing the optical adjustment operation, and also attaching the reticle stage and the wafer stages made up of multiple mechanical parts to the main body of the exposure apparatus, connecting the wiring and piping, and then, further performing total adjustment (such as electrical adjustment and operation check). The exposure apparatus is preferably built in a clean room where conditions such as the temperature and the degree of cleanliness are controlled.

The present invention is not limited to the exposure apparatus for manufacturing semiconductors, and the present invention can also be applied to an exposure apparatus used for manufacturing liquid crystal displays that transfers a liquid crystal display device pattern onto a glass plate, an exposure apparatus used for manufacturing thin film magnetic heads that transfers a device pattern onto a ceramic wafer, and to an exposure apparatus used for imaging devices (such as CCDs), micromachines, organic ELs, DNA chips, and the like. Further, the present invention can also be suitably applied to an exposure apparatus that transfers a circuit pattern onto a glass substrate or a silicon wafer not only when producing microdevices such as semiconductors, but also when producing a reticle or a mask used in exposure apparatus such as an optical exposure apparatus, an EUV exposure apparatus, an X-ray exposure apparatus, and an electron beam exposure apparatus. Normally, the exposure apparatus that uses DUV (deep (far) ultraviolet) light or VUV (vacuum ultraviolet) light, a transmittance type reticle is used, and as the reticle substrate, materials such as silica glass, fluorine-doped silica glass, fluorite, magnesium fluoride, or crystal are used. Further, in an X-ray exposure apparatus by the proximity method, or in an electron beam exposure apparatus, a transmittance type mask (a stencil mask, a membrane mask) is used, and as the mask substrate, silicon wafer or the like is used.

### Device manufacturing method

Next, an embodiment will be described of a device manufacturing method that uses the above exposure apparatus in the lithography step.

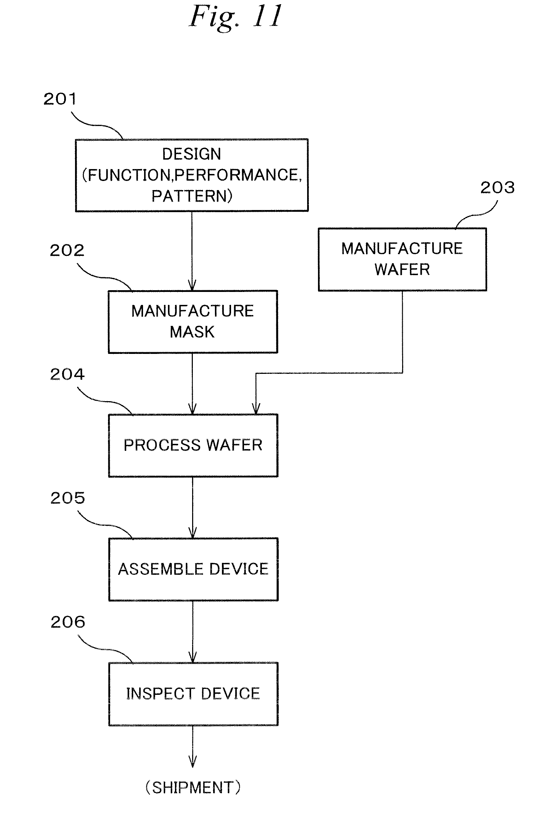

FIG. 11 shows the flowchart of an example when manufacturing a device (a semiconductor chip such as an IC or an LSI, a liquid crystal panel, a CCD, a thin-film magnetic head, a micromachine, and the like). As shown in FIG. 11, in step 201 (design step), function and performance design of device (circuit design of semiconductor device, for example) is performed first, and pattern design to realize the function is performed. Then, in step 202 (mask manufacturing step), a mask on which the designed circuit pattern is formed is manufactured. Meanwhile, in step 203 (wafer manufacturing step), a wafer is manufactured using materials such as silicon.

Next, in step 204 (wafer processing step), the actual circuit and the like are formed on the wafer by lithography or the like in a manner that will be described later, using the mask and the wafer prepared in steps 201 to 203. Then, in step 205 (device assembly step), device assembly is performed using the wafer processed in step 204. Step 205 includes processes such as the dicing process, the bonding process, and the packaging process (chip encapsulation), and the like when necessary.

Finally, in step 206 (inspection step), tests on operation, durability, and the like are performed on the devices made in step 205. After these steps, the devices are completed and shipped out.

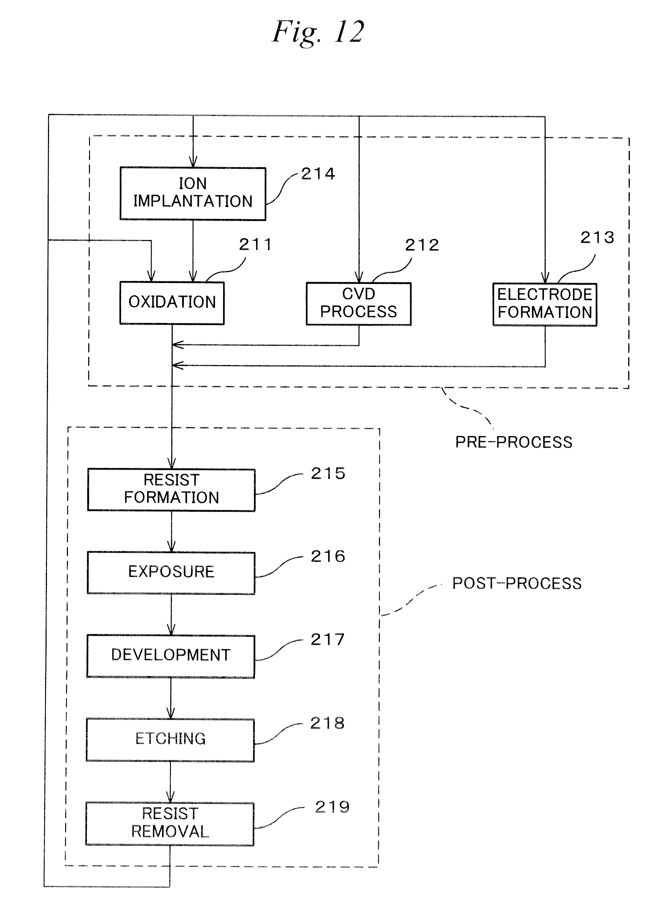

FIG. 12 is a flow chart showing a detailed example of step 204 described above. Referring to FIG. 12, in step 211 (oxidation step), the surface of wafer is oxidized. In step 212 (CDV step), an insulting film is formed on the wafer surface. In step 213 (electrode formation step), an electrode is formed on the wafer by deposition. In step 214 (ion implantation step), ions are implanted into the wafer. Each of the above steps 211 to 214 constitutes the pre-process in each step of wafer processing, and the necessary processing is chosen and is executed at each stage.

When the above-described pre-process ends in each stage of wafer processing, post-process is executed as follows. In the post-process, first in step 215 (resist formation step), a photosensitive agent is coated on the wafer. Then, in step 216 (exposure step), the circuit pattern of the mask is transferred onto the wafer by the lithography system (exposure apparatus) and the exposure method of the embodiment above. Next, in step 217 (development step), the exposed wafer is developed, and in step 218 (etching step), an exposed member of an area other than the area where resist remains is removed by etching. Then, in step 219 (resist removing step), when etching is completed, the resist that is no longer necessary is removed.

By repeatedly performing the pre-process and the post-process, multiple circuit patterns are formed on the wafer.

When the above device manufacturing method of the embodiment described above is used, because the exposure apparatus of the embodiment above is used in the exposure process (step 216), exposure with high throughput can be performed without degrading the exposure accuracy. Accordingly, the productivity of high integration microdevices on which fine patterns are formed can be improved.

The exposure method and exposure apparatus of the present invention are suitable for alternately performing exposure on substrates that are placed on two substrate stages. Further, the stage unit of the present invention is suitably used in the exposure apparatus of the present invention. Still further, the device manufacturing method of the present Invention is suitable for producing microdevices.

## Claims

1. An exposure apparatus that alternately performs exposure processing with respect to substrates on two substrate stages, said apparatus comprising:
an exposure optical system that exposes a substrate on each of said two substrate stages positioned in the vicinity of a predetermined first position;
a mark detection system that detects a mark formed on a substrate on each of said two substrate stages positioned at a second position different from said first position; and
an exchange unit that switches said both substrate stages in between an exposure operation of a substrate by said exposure optical system and a mark detection operation of said substrate by said mark detection system, in a procedure where a specific stage, which is at least one of said two substrate stages, is temporarily positioned below the remaining substrate stage.

2. The exposure apparatus of Claim 1 wherein
said exchange unit makes said specific stage wait below said remaining substrate stage.

3. The exposure apparatus of Claim 1 wherein
said specific stage is one substrate stage of said two substrate stages, and
said exchange unit moves said specific stage via the lower side of the other stage.

4. The exposure apparatus of Claim 3 wherein
said exchange unit includes
a first vertical mechanism that vertically moves said specific stage between said second position and a third position below said second position, and
a second vertical mechanism that vertically moves said specific stage between a fourth position on the opposite side of said second position with respect to said first position and a fifth position below said fourth position.

5. An exposure apparatus that performs exposure processing on a substrate held on a stage that can move along a predetermined plane, said apparatus comprising:
a drive unit connecting to said stage that drives said stage along said predetermined plane; and
a vertical movement mechanism that moves said stage and at least a part of said drive unit in a direction intersecting said predetermined plane.

6. The exposure apparatus of Claim 5, said apparatus further comprising:
an exposure optical system, wherein
when said stage moves along said predetermined plane, an image-forming plane of said exposure optical system can be positioned on said substrate held on said stage.

7. The exposure apparatus of Claim 5 wherein
said drive unit can move said stage in said direction intersecting said predetermined plane independently from said vertical movement mechanism.

8. The exposure apparatus of Claim 5 wherein
a predetermined first position where exposure processing of said substrate held on said stage is performed and a second position where a processing different from said exposure processing is performed on said substrate are set, and
said vertical movement mechanism moves said stage and at least a part of said drive unit in said direction intersecting said predetermined plane in the vicinity of said second position.

9. The exposure apparatus of Claim 8 wherein
said second position includes a loading position of said substrate.

10. The exposure apparatus of Claim 8, said apparatus further comprising:
a mark detection system arranged in the vicinity of said second position that detects marks formed on said substrate.

11. The exposure apparatus of Claim 5, said apparatus further comprising:
a first guide surface that supports said stage when said stage moves along said predetermined plane, and
a second guide surface that supports said stage, which moves in said direction intersecting said predetermined plane, by said vertical movement mechanism.

12. The exposure apparatus of Claim 11 wherein
said vertical movement mechanism moves said second guide surface in said direction intersecting said predetermined plane.

13. A device manufacturing method including a lithography process wherein
in said lithographic process, exposure is performed using an exposure apparatus in any one of Claims 1 to 12.

14. A stage unit, said unit comprising:
a stage that can move along a predetermined plane;
a first drive unit connected, to said stage that makes said stage move along said predetermined plane;
a vertical movement mechanism that moves said stage and at least a part of said first drive unit in a direction intersecting said predetermined plane.

15. The stage unit of Claim 14, said unit further comprising:
a first guide surface that supports said stage when said stage moves along said predetermined plane, and
a second guide surface that that supports said stage that moves in said direction intersecting said predetermined plane by said vertical movement mechanism; and
a second drive unit that drives said stage supported by said second guide surface.

16. The stage unit of Claim 15 wherein
said vertical movement mechanism moves said second guide surface in said direction intersecting said predetermined plane.

17. A stage unit that alternately moves two stages with respect to a predetermined position for performing a predetermined processing, said unit comprising:
an exchange unit that moves only one stage of said two stages so that said one stage is temporarily positioned under the other stage.

18. The stage unit of Claim 17 wherein
said exchange unit includes a vertical movement mechanism that vertically moves said one stage so as to position said one stage lower than a moving plane of said other stage.
